# EUROPEAN PATENT APPLICATION

(11) **EP 2 657 240 A1**
(43) Date of publication of application: **30.10.2013**
(21) Application number: 13002020.9
(22) Date of filing: 17.04.2013
(51) Int. Cl.: C07F 7/18, C09D 183/06, C08L 83/06, G03F 7/40, H01L 21/30

(54) **Silicon compound, silicon-containing compound, composition for forming resits underlayer film containing the same and patterning process**

(30) Priority: 23.04.2012 JP 2012097507
(71) Applicant: Shin-Etsu Chemical Co., Ltd., Chiyoda-ku, Tokyo (JP)
(72) Inventor: Tsutomu, Ogihara, Jyoetsu-shi, Niigata-ken (JP); Takafumi, Ueda, Jyoetsu-shi, Niigata-ken (JP); Yoshinori, Taneda, Jyoetsu-shi, Niigata-ken (JP); Masahiro, Kanayama, Jyoetsu-shi, Niigata-ken (JP)
(74) Representative: Wibbelmann, Jobst

(57) **Abstract**

The invention provides a silicon compound represented by the following general formula (A-1) or (A-2), 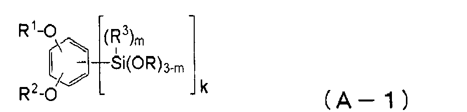 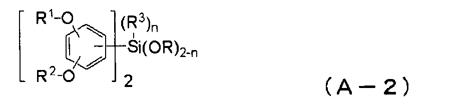 wherein, R represents a hydrocarbon group having 1 to 6 carbon atoms, R¹ and R² represent an acid labile group, R³ represents a hydrogen atom or a monovalent organic group having 1 to 30 carbon atoms, k represents an integer of 1 or 2, m represents an integer of 0, 1, or 2, and n represents an integer of 0 or 1.

There can be provided a resist underlayer film that can be applied not only to a resist pattern formed by a hydrophilic organic compound obtained in negative development but also to a resist pattern composed of a hydrophobic compound obtained in conventional positive development.

## Description

### BACKGROUND OF THE INVENTION

### Field of the Invention

The present invention relates to a silicon compound, a silicon-containing compound, a composition for forming a resist underlayer film containing the same, and a patterning process.

### Description of the Related Art

In the 1980s, exposure light whose source is g beam (436nm) or i beam (365nm) of a mercury lamp was commonly used for resist patterning. To achieve a further miniaturization, a method for making an exposure wavelength shorter has been regarded as more effective means. In the 1990s, 64M-bit (work size: less than 0.25µm) Dynamic Random Access Memory (DRAM) and subsequent electronic devices were mass produced, in which short-wavelength KrF excimer lasers (248nm) were employed as an exposing source instead of the i beam (365nm). In reality, however, the production of DRAMs with an integration degree of 256M and more than 1G requires finer processing technology (work size: less than 0.2µm), and needs a light source of a shorter wavelength. Amid this technological need, the introduction of photography by ArF excimer lasers (193nm) has been seriously examined since about a decade ago. According to initial plan, ArF lithography was introduced into the production of 180nm-node devices, but a conventional KrF excimer lithography was continuously used until 130nm-node device mass production. Therefore, the full-fledged application of ArF lithography started from the 90-nm node devices. Meanwhile, mass production of 65nm-node devices, having lenses whose numerical aperture (NA) was raised to 0.9, are being promoted. Because of advantageous shorter wavelength of exposure, F₂ lithography with a wavelength of 157nm was regarded as a next promising production technology for subsequent 45nm-node devices. However, development of F₂ lithography was canceled due to several problems such as higher scanner costs from expensive CaF₂ single crystals into projection lenses in large volumes, change in the optical system in accordance with introduction of hard pellicles instead of conventional extremely low durable soft pellicles, and reduced etch resistance of a resist film, thereby introducing ArF immersion lithography.

In ArF immersion lithography, water with a refractive index of 1.44 is inserted between a projection lens and a wafer by partial fill method, enabling highspeed scanning. Accordingly, 45nm-node devices are mass produced by using lenses with an NA of 1.3.

Extreme-ultraviolet (EUV) lithography with a wavelength of 13.5nm is regarded as a next promising 32nm-node lithography technology. The EUV lithography is prone to numerous technical problems such as needs for higher laser output, higher sensitivity of a resist film, higher resolution, lower line edge roughness (LER), defect-free MoSi laminated mask, and lower aberration of a reflective mirror.

Development of another promising 32nm-node device production technology, or high-refractive index immersion lithography, was canceled due to low transmission factor of another promising high-refractive index lens (LUAG) and an inability to obtain a desired value of a refractive index of liquid at 1.8.

As described above, light exposure used as the general purpose technology approaches the limit of essential resolution introduced by the wavelength of a light source. As another technical solution, extremely fine holes that conventional positive-tone alkaline development cannot pattern will be patterned by negative-tone organic solvent development. In recent years, this patterning technology has again received much technological attention. Specifically, this process negatively patterns by organic solvent development, by using a high-resolution positive resist composition. Moreover, an attempt to double the resolution is being made by a combination of alkaline development and organic solvent development.

Illustrative example of the ArF resist composition for negative tone development by the organic solvent includes a conventional positive ArF resist composition such as patterning processs as shown in Patent Documents 1 to 3.

A method for transferring on a substrate a negative-tone pattern thus formed is a multilayer resist method. Specifically, this method is a method for intermediating a middle layer having an etching selectivity different from a photoresist film or a resist upper layer film, such as a silicon-containing resist underlayer film, between the resist upper layer film and a substrate to be processed to pattern on the resist upper layer film, transferring the pattern on the silicon-containing resist underlayer film by dry etching with a upper resist pattern as a dry etching mask, and further transferring the pattern on the substrate to be processed by dry etching with the silicon-containing resist underlayer film as a dry etching mask.

Illustrative example of the silicon-containing resist underlayer film used in this multilayer resist method includes a CVD silicon-containing inorganic film such as an SiO₂ film (Patent Document 4 and so on) and an SiON film (Patent Document 5 and so on), and illustrative example of a spin-coating film includes a spin-on glass (SOG) film (Patent Document 6 and so on) and a crosslinking silsesquioxane film (Patent Document 7 and so on).

Patent Document 1: Japanese Unexamined Patent Publication No. 2008-281974
Patent Document 2: Japanese Unexamined Patent Publication No. 2008-281980
Patent Document 3: Japanese Unexamined Patent Publication No. 2009-53657
Patent Document 4: Japanese Unexamined Patent Publication No. H7-183194
Patent Document 5: Japanese Unexamined Patent Publication No. H7-181688
Patent Document 6: Japanese Unexamined Patent Publication No. 2007-302873
Patent Document 7: Japanese Unexamined Patent Publication No. 2005-520354

### SUMMARY OF THE INVENTION

In fact, positive development (alkaline development) forms a resist pattern composed of a hydrophobic compound that doesn't dissolve in an alkaline developer. Unlike this, negative development (organic solvent development) forms a resist pattern composed of a hydrophilic organic compound having a high concentration of acid carboxyl group by deprotection reaction. Thus, a conventional resist underlayer film for alkaline development unfortunately fails to sufficiently provide performance of an upper layer resist.

Meanwhile, if a resist underlayer film used in negative development and a resist underlayer film used in positive development vary, different piping facilities are required for each film, resulting in an economically disadvantageous technology.

The present invention was made to solve the problems mentioned above, and was intended to provide a resist underlayer film that can be applied not only to a resist pattern formed in a hydrophilic organic compound obtained by negative development, but also to a resist pattern composed of a hydrophobic compound obtained by conventional positive development.

To solve the problems as mentioned above, the present invention provides a silicon compound represented by the following general formula (A-1) or (A-2), 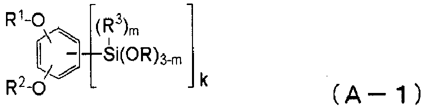 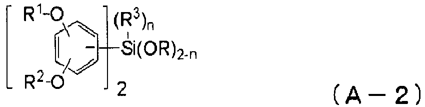 wherein, R represents a hydrocarbon group having 1 to 6 carbon atoms, R¹ and R² represent an acid labile group, R³ represents a hydrogen atom or a monovalent organic group having 1 to 30 carbon atoms, k represents an integer of 1 or 2, m represents an integer of 0, 1 or 2, and n represents an integer of 0 or 1.

A resist underlayer film obtained from a silicon-containing resist underlayer film material obtained by the silicon compound of the present invention as a raw material can be applied not only to a resist pattern formed in a hydrophilic organic compound obtained in negative development, but also to a resist pattern composed of a hydrophobic compound obtained by conventional positive development.

It is preferable that an acid labile group of R¹ and R² in the general formula be an acetal group or a tertiary alkyl group.

If R¹ and R² in the general formula are an acetal group or a tertiary alkyl group, a silicon-containing resist underlayer film obtained from the silicon compound of the present invention as a raw material can have a contact angle which is close to a photoresist film.

The present invention provides a silicon-containing compound comprising at least one or more kinds of the repeating units represented by the following general formulae (B), (C), (D), and (E), 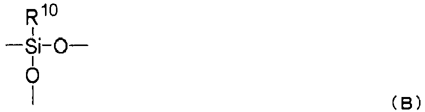 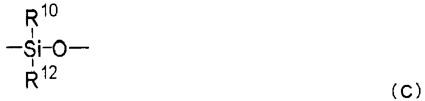 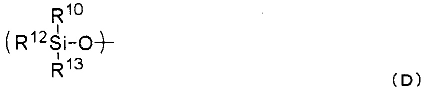 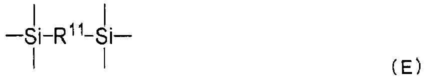 wherein, 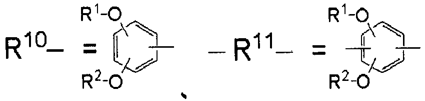 R¹ and R² are an acid labile group, R¹² and R¹³ are any of the R¹⁰, a hydrogen atom or a monovalent organic group having 1 to 30 carbon atoms, and if either one of the two is R¹⁰, R¹²≠R¹³.

A resist underlayer film obtained by a silicon-containing compound containing one or more kinds of the repeating units represented by the general formula (B), (C), (D), and (E) can be applied not only to a resist pattern formed in a hydrophilic organic compound obtained in negative development, but also to a resist pattern composed of a hydrophobic compound obtained by conventional positive development.

The present invention provides a silicon-containing composition for forming a resist underlayer film comprising the silicon-containing compound and a solvent.

The use of a resist underlayer film formed by using the silicon-containing composition for forming a resist underlayer film of the present invention provides excellent adhesiveness with the resist underlayer film and no pattern fall, both in positive development (alkaline development) and in negative development (organic solvent development), thereby enabling a resist patterning process with a favorable surface roughness.

The present invention provides a patterning process comprising a step of forming an organic underlayer film on a body to be processed by using an application-type composition for organic underlayer film; a step of forming a silicon-containing resist underlayer film on the organic underlayer film by using the silicon-containing composition for forming a resist underlayer film; a step of forming a photoresist film on the silicon-containing resist underlayer film by using a chemically-amplified resist composition; a step of, after a heat-treatment, forming a positive pattern by exposure of the photoresist film by a high energy radiation and by dissolution of an exposed area of the photoresist film by using an alkaline developer; a step of transferring the pattern on the silicon-containing resist underlayer film by dry etching with the photoresist film having the formed positive pattern as a mask; a step of transferring the pattern on the organic underlayer film by dry etching with the silicon-containing resist underlayer film having the transferred pattern as a mask; and a step of further transferring the pattern on the body to be processed by dry etching with the organic underlayer film having the transferred pattern as a mask.

In addition, the present invention provides a patterning process comprising a step of forming an organic hard mask mainly comprising carbon on a body to be processed by CVD method; a step of forming a silicon-containing resist underlayer film on the organic hard mask by using the above silicon-containing composition for forming a resist underlayer film; a step of forming a photoresist film on the silicon-containing resist underlayer film by using a chemically-amplified resist composition; a step of, after a heat-treatment, forming a positive pattern by exposure of the photoresist film by a high energy radiation and by dissolution of an exposed area of the photoresist film by using an alkaline developer; a step of transferring the pattern on the silicon-containing resist underlayer film by dry etching with the photoresist film having the formed positive pattern as a mask; a step of transferring the pattern on the organic hard mask by dry etching with the silicon-containing resist underlayer film having the transferred pattern as a mask; and a step of further transferring the pattern on the body to be processed by dry etching with the organic hard mask having the transferred pattern as a mask.

Moreover, the present invention provides a patterning process comprising a step of forming an organic underlayer film on a body to be processed by using an application-type composition for organic underlayer film; a step of forming a silicon-containing resist underlayer film on the organic underlayer film by using the above silicon-containing composition for forming a resist underlayer film; a step of forming a photoresist film on the silicon-containing resist underlayer film by using a chemically-amplified resist composition; a step of, after a heat-treatment, forming a negative pattern by exposure of the photoresist film by a high energy radiation and by dissolution of a non-exposed area of the photoresist film by using a developer of an organic solvent; a step of transferring the pattern on the silicon-containing resist underlayer film by dry etching with the photoresist film having the formed negative pattern as a mask; a step of transferring the pattern on the organic underlayer film by dry etching with the silicon-containing resist underlayer film having the transferred pattern as a mask; and a step of further transferring the pattern on the body to be processed by dry etching with the organic underlayer film having the transferred pattern as a mask.

Also, the present invention provides a patterning process comprising a step of forming an organic hard mask mainly comprising carbon on a body to be processed by CVD method; a step of forming a silicon-containing resist underlayer film on the organic hard mask by using the above silicon-containing composition for forming a resist underlayer film; a step of forming a photoresist film on the silicon-containing resist underlayer film by using a chemically-amplified resist composition; a step of, after a heat-treatment, forming a negative pattern by exposure of the photoresist film by a high energy radiation and by dissolution of a non-exposed area of the photoresist film by using a developer of an organic solvent; a step of transferring the pattern on the silicon-containing resist underlayer film by dry etching with the photoresist film having the formed negative pattern as a mask; a step of transferring the pattern on the organic hard mask by dry etching with the silicon-containing resist underlayer film having the transferred pattern as a mask; and a step of further transferring the pattern on the body to be processed by dry etching with the organic hard mask having the transferred pattern as a mask.

By patterning by using the composition for forming a resist underlayer film of the present invention, optimization of a combination of a CVD film and an organic underlayer film as described above can form a pattern that is formed on a photoresist on a substrate without a size conversion difference.

In the negative and positive patterning process, the body to be processed is preferably a semiconductor device substrate, and or a semiconductor device substrate coated with any of a metal film, an alloy film, a metal carbide film, a metal oxide film, a metal nitride film, a metal oxicarbide film, and a metal oxinitride film as a layer to be processed.

In the patterning process, a metal composed of the body to be processed preferably comprises a silicon, a gallium, a titanium, a tungsten, a hafnium, a zirconium, a chromium, a germanium, a copper, an aluminum, an iron or an alloy thereof.

By using the patterning process of the present invention, the body to be processed as described above can be processed to pattern.

A resist underlayer film is formed by using a composition for forming a resist underlayer film containing a silicon-containing compound comprising the silicon compound of the present invention. A use of the resist underlayer film provides a favorable adhesiveness with the resist underlayer film and no pattern fall, both in positive development (alkaline development) and negative development (organic solvent development), thereby enabling a resist patterning process with a favorable surface roughness. Moreover, the silicon-containing resist underlayer film can obtain a high etching selectivity with an organic material, resulting in transfer of a formed photoresist pattern into a silicon-containing resist underlayer film, an organic underlayer film or a CVD organic hard mask in sequence by using dry etching process. In particular, recent processes for producing a semiconductor device, characterized by finer processing technology, make a photoresist film thickness smaller to prevent pattern fall after development. This trend unfortunately leads to more difficult pattern transfer into a resist underlayer film. Nevertheless, a use of the silicon-containing composition for forming a resist underlayer film of the present invention can prevent the deformation of a photoresist pattern during dry etching, even using a thin photoresist film as an etching mask, and can precisely transfer this pattern into a substrate.

In actual steps for producing a semiconductor device by using positive development, not all patterning steps but a small part of ultrafine steps are replaced with negative development. Obviously, conventional positive development will be still used. If resist underlayer films are produced by different processing devices according to negative and positive development, the device structure and the way for composition quality control will be more complex. Therefore, the introduction of a resist underlayer film material that can be applied in both positive and negative development, as shown in the present invention, can achieve technically-favorable and economical production in view of simple device structure and quality control.

### BRIEF DESCRIPTION OF THE DRAWINGS

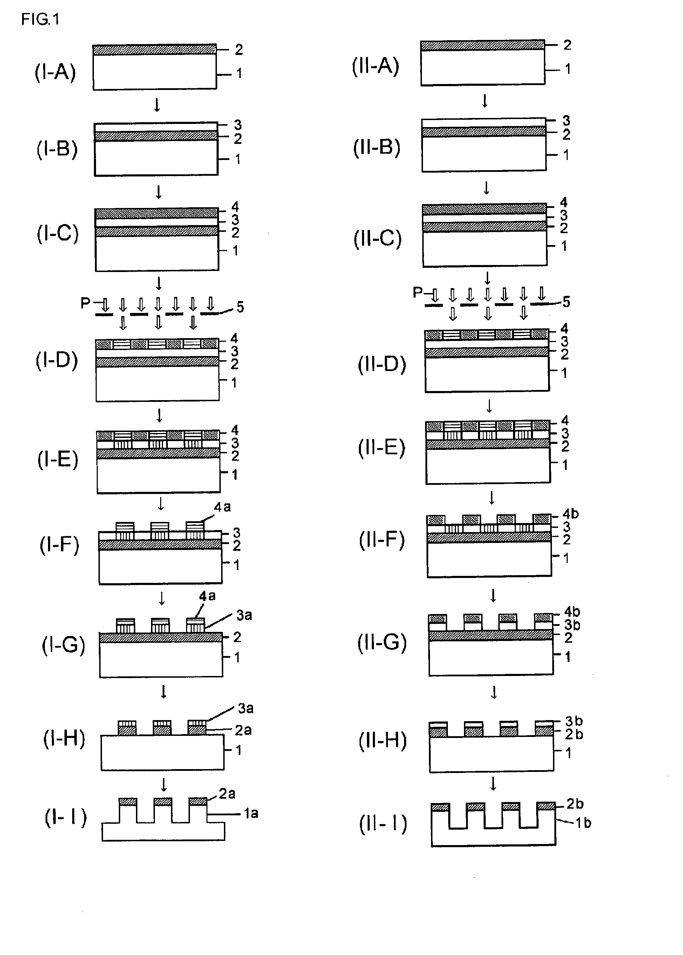

Fig. 1 is a flow diagram showing a patterning process of the present invention.

### DETAILED DESCRIPTION OF THE PREFERRED EMBODIMENTS

The present invention will be described in more detail, but the present invention is not restricted thereto.
In conventional positive photoresist technology, a quality of a photoresist film before exposure and a quality of a film of a pattern formed by alkaline development after exposure (hereinafter called as positive pattern) are the same. Thus, the adhesiveness between a positive pattern and a resist underlayer film can be improved and the roughness can be reduced, by making closer contact angles of the photoresist and the resist underlayer film to purified water (hereinafter called as contact angle).

However, in a pattern obtained by negative development (hereinafter called as negative pattern), comparison of qualities of a photoresist film before exposure and a film of a negative pattern after exposure found that a negative pattern removes an acid labile group due to an acid generated by exposure, and an amount of a hydrophilic group such as a carboxyl group and a phenol hydroxyl group increases. This change reduces the contact angle, showing more hydrophilic property than the photoresist film before exposure. Therefore, in the patterning process by using both the above-mentioned negative development and positive development, use of a conventional positive resist underlayer film, whose contact angle was matched with a contact angle of a photoresist film before exposure, found some impacts on negative pattern fall and roughness from a resulting larger contact angle with negative pattern after exposure.

Inventors of the present invention carried out an extensive investigation to find that a resist underlayer film is provided with an optimal surface state in both negative and positive patterning processs, if the resist underlayer film has a contact angle close to a contact angle of a photoresist film of a non-exposed area to purified water before exposure and a contact angle close to a contact angle of a photoresist film in an exposed area after exposure, by using the photoresist film of the non-exposed area as a positive pattern and the photoresist film of the exposed area as a negative pattern. Then, a silicon-containing resist underlayer film material that reduces a contact angle only in the exposed area was intensively examined. By blending a silicon-containing compound containing an organic group having a carboxyl group substituted with an acid labile group or a phenol hydroxyl group into a resist underlayer film composition with an appropriate ratio, a silicon-containing composition for forming a resist underlayer film can be obtained, so that an acid generated by exposure removes an acid labile group, an amount of a hydrophilic group such as a carboxyl group and a phenol hydroxyl group increases, and a contact angle of a resist pattern is reduced, showing more hydrophilic property than after coating; and as a result, the present invention could be accomplished.

The present invention provides a silicon compound represented by the following general formula (A-1) or (A-2), 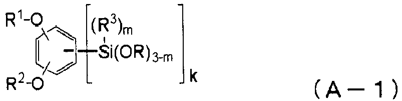 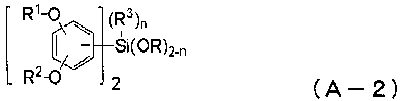 wherein, R represents a hydrocarbon group having 1 to 6 carbon atoms, R¹ and R² are an acid labile group, R³ represents a hydrogen atom or a monovalent organic group having 1 to 30 carbon atoms, k represents an integer of 1 or 2, m represents an integer of 0, 1, or 2, and n represents an integer of 0 or 1.

A resist underlayer film that can obtain the silicon compound of the present invention as a raw material has a contact angle close to a contact angle of a positive development pattern of an upper resist in a non-exposed area. Therefore, positive development can improve the adhesiveness with an upper resist and prevent pattern fall even in fine line pattern. In addition, a silicon-containing resist underlayer film obtained from the composition of the present invention eliminates an acid labile group contained in a molecular structure in an exposed area due to an acid action generated by an upper resist and generates a phenol hydroxyl group. The effect of this hydroxyl group makes smaller a contact angle of a resist underlayer film surface than conventionally known compounds. Consequently, in negative developing process, the adhesiveness in negative development pattern between a more hydrophilic upper resist and a resist underlayer film is improved and pattern fall can be prevented even in fine line pattern.

A method for producing the silicon compound of the present invention will be described.
An acid labile group is introduced into a phenolic compound as a raw material.
Preferable example of the acid labile group is a tertiary alkyl group or an alkoxyalkyl group (acetal group), 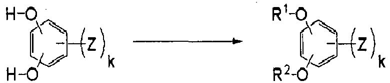 wherein, Z represents chlorine, bromine or iodine, R¹ and R² are an acid labile group, and k represents an integer of 1 or 2.
Illustrative example of the phenolic compound as a raw material includes the following compounds.

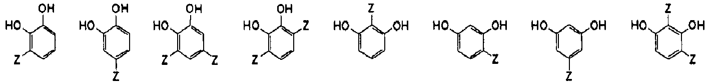

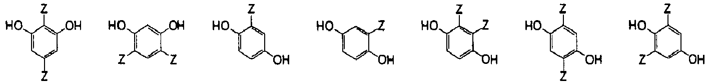

Illustrative example of the tertiary alkyl group includes a tert-butyl group, a triethylcarbyl group, a 1-ethyl norbonyl group, a 1-methylcyclohexyl group, a 1-ethylcyclopentyl group, a 2-(2-methyl) adamantyl group, a 2-(2-ethyl) adamantyl group, a tert-amyl group, a tert-hexyl group, and the groups represented by the following general formulae (4)-1 to (4)-17.

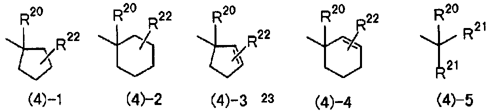

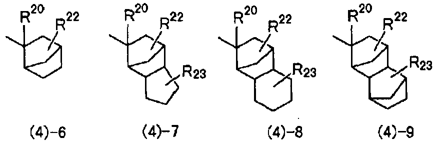

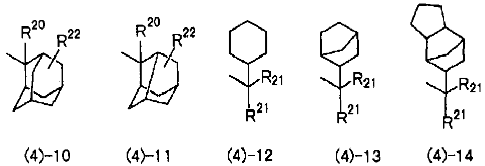

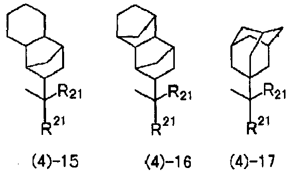

R²⁰ in the general formula (4) represents a linear, a branched or a cyclic alkyl group having 1 to 6 carbon atoms, or an aryl group having 6 to 20 carbon atoms, and specific example thereof includes a methyl group, an ethyl group, a propyl group, an isopropyl group, an n-butyl group, a sec-butyl group, an n-pentyl group, an n-hexyl group, a cyclopropyl group, a cyclopropylmethyl group, a cyclobutyl group, a cyclopentyl group, a cyclohexyl group, a phenyl group, a methylphenyl group group, an ethylphenyl group, a naphthyl group, a methylnaphthyl group, and an ethylnaphthyl group. R²¹ represents a linear, a branched or a cyclic alkyl group having 2 to 6 carbon atoms, and specific example thereof includes an ethyl group, a propyl group, an isopropyl group, an n-butyl group, a sec-butyl group, an n-pentyl group, an n-hexyl group, a cyclopropyl group, a cyclopropylmethyl group, a cyclobutyl group, a cyclopentyl group, and a cyclohexyl group. R²² and R²³ represent a hydrogen atom or a monovalent hydrocarbon group having 1 to 6 carbon atoms (a hetero atom may be contained.). Illustrative example of the hetero atom includes an oxygen atom, a sulfur atom, and a nitrogen atom, and can contain or mediate as -OH, -OR²⁴ (R²⁴ represents an alkyl group.), -O-, -S-, -S(=O)-, -NH₂, - NHR²⁴-, NR²⁴₂, -NH-, and -NR²⁴⁻.

Illustrative example of the R²² and R²³ includes a hydrogen atom, an alkyl group, a hydroxyalkyl group, an alkoxy group, and an alkoxyalkyl group, and may be any of a linear, a branched, or a cyclic group. Specific example thereof includes a methyl group, a hydroxymethyl group, an ethyl group, a hydroxyethyl group, a propyl group, an isopropyl group, an n-butyl group, a sec-butyl group, an n-pentyl group, an n-hexyl group, a methoxy group, a methoxymethoxy group, an ethoxy group, and a tert-butoxy group.

The acetal group can be represented by the following general formula (5).

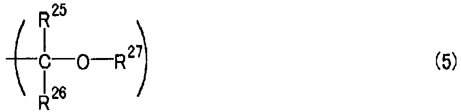

R²⁷ in the general formula (5) represents a linear, a branched, or a cyclic alkyl group having 1 to 20 carbon atoms, or an aryl group having 6 to 20 carbon atoms, and may contain a hetero atom such as oxygen, sulfur, nitrogen, and fluorine.

R²⁵ and R²⁶ in the general formula (5) represent a hydrogen atom or a linear, a branched, or a cyclic alkyl group having 1 to 20 carbon atoms, and can contain a hetero atom such as oxygen, sulfur, nitrogen, and fluorine, and R²⁵ and R²⁶, R²⁵ and R²⁷, and R²⁶ and R²⁷ may be combined to form a ring.

Illustrative example of the acetal group includes the groups represented by the following general formulae (6)-1 to (6)-25.

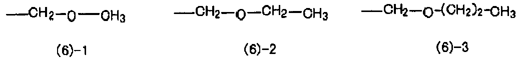

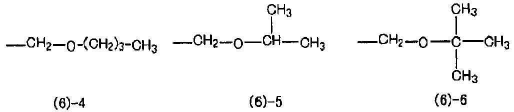

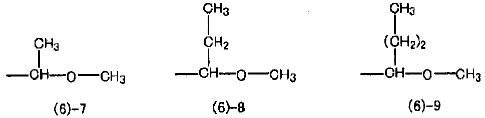

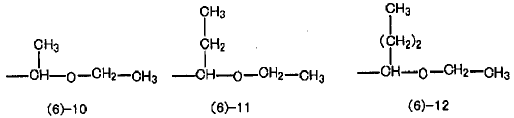

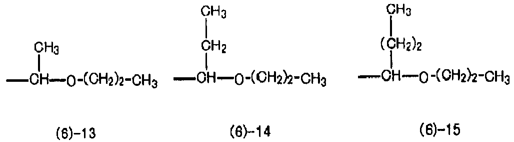

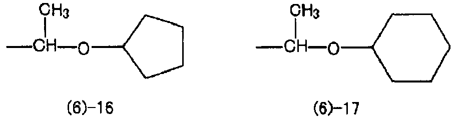

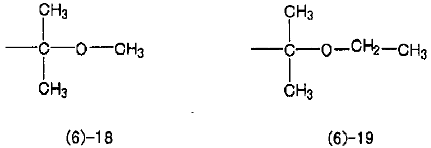

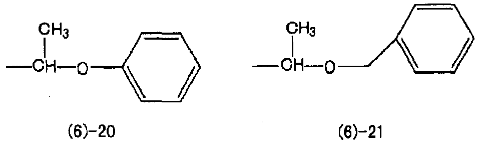

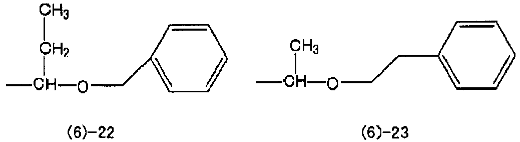

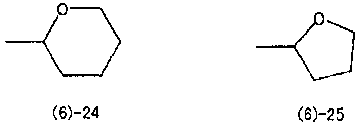

An acid labile group can be introduced into the phenolic compound, normally by the action of an olefin compound corresponding to the acid labile group, by using no solvent or an acid or a base in a solvent as a catalyst at room temperature or by cooling or heating as required. Illustrative example of the solvent includes an alcohol such as a methanol, an ethanol, an isopropyl alcohol, a butanol, an ethylene glycol, a propylene glycol, a diethylene glycol, a glycerol, a methyl cellosolve, an ethyl cellosolve, a butyl cellosolve, and a propylene glycolmonomethyl ether; an ether such as a diethyl ether, a dibutyl ether, a diethylene a glycoldiethyl ether, a diethylene glycoldimethyl ether, a tetrahydrofuran, and a 1,4-dioxane; a chlorine solvent such as a methylene chloride, a chloroform, a dichloroethane, and a trichloroethylene; a hydrocarbon such as a hexane, a heptane, a benzene, a toluene, a xylene, and a cumene; a nitrile such as an acetonitrile; a ketone such as an acetone, an ethyl methyl ketone, and an isobutyl methyl ketone; an ester such as an ethyl acetate, an n-butyl acetate, and a propylene glycol methyl ether acetate; a lactone such as a γ-butyrolactone; and an aprotic polar solvent such as a dimethyl sulfoxide, an N,N-dimethylformamide, and a hexamethyl phosphoric triamide, and can be used alone or in combination with two or more kinds thereof. Any of these solvents can be used in the range of 0 to 2,000 parts by mass, relative to 100 parts by mass of a reactant.

Illustrative example of the acid catalyst includes an inorganic acid such as a hydrochloric acid, a hydrobromic acid, a sulfuric acid, a nitric acid, a phosphoric acid, and a heteropoly acid; an organic acid such as an oxalic acid, a trifluoroacetic acid, a methanesulfonic acid, a benzenesulfonic acid, a p-toluenesulfonic acid, and trifluoromethanesulfonic acid; a Lewis acid such as an aluminium trichloride, an aluminium ethoxide, an aluminum isopropoxide, a boron trifluoride, a boron trichloride, a boron tribromide, a tin tetrachloride, a tin tetrabromide, a dibutyltin dichloride, a dibutyltin dimethoxide, a dibutyltin oxide, a titanium tetrachloride, a titanium tetrabromide, a titanium (IV) methoxide, a titanium (IV) ethoxide, a titanium (IV) isopropoxide, and a titanium oxide (IV). Any of these acid catalysts can be used in the range of preferably 0.001 to 100% by mass, and more preferably 0.005 to 50% by mass, relative to a raw material. The reaction temperature is preferably in the range of -50°C to a boiling point of a solvent, and more preferably in the range of room temperature to 100°C.

A silicon compound can be produced from a phenolic compound into which an acid labile group is introduced.
Typically, a silicon compound can be produced by preparing an organometallic reagent from the phenolic compound obtained by the method and substituting the organometallic reagent with an alkoxysilane. A silicon compound can be selectively produced whose k value is 1 or 2, by changing the ratio of the organometallic reagent and the alkoxysilane, 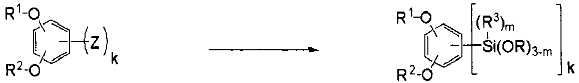 wherein, Z represents a chlorine, a bromine, or an iodine, R represents a hydrocarbon group having 1 to 6 carbon atoms, R¹ and R² represent an acid labile group, R³ represents a hydrogen atom or a monovalent organic group having 1 to 30 carbon atoms, k represents an integer of 1 or 2, m represents an integer of 0, 1, or 2, and n represents an integer of 0 or 1.

Illustrative example of the organometallic reagent includes a Grignard reagent and an organolithium reagent, and the Grignard reagent and the organolithium reagent are particularly preferable. The Grignard reagent and the organolithium reagentmay be prepared by direct metalation with a 4,4'-dihalobiphenyl, and a magnesium metal or a lithium metal, and by metal-halogen exchange reaction with an aliphatic organometallic compound such as a isopropyl magnesium halide, a methyl lithium halide, and a butyl lithium halide.

Illustrative example of the solvent used in the reaction of the organometallic reagent and the alkoxysilane includes an ether such as a diethyl ether, a dibutyl ether, a tetrahydrofuran, a 1,4-dioxane, and a cyclopentylmethylether; a hydrocarbon such as a benzene, a toluene, a xylene, a mesitylene, a hexane, a heptane, an octane, and an isooctane; and an aprotic polar solvent such as an N,N,N',N'-tetramethylethylene diamine, a hexamethylphosphorictriamide, and an N,N-dimethylformamide, and can be used alone or in combination with two or more kinds thereof. The reaction temperature depends on the kind of an organometallic reagent and reaction conditions, but preferably in the range of -70 to 150°C, and can be selected e.g. in the range of -70 to 0°C in the case of using organolithium reagent, or in the range of room temperature to a boiling point of a solvent under reflux in the case of using a Grignard reagent. The reaction duration is preferably from reaction tracking by chromatography to the completion, but may normally be from 30 minutes to 48 hours.

The reaction mixture obtained can be purified by concentrating a desired product by filtration and solvent elimination, and simple distillation, rectification, and recrystallization of a crude product obtained.

Illustrative example of the silicon compound of the present invention includes the structures represented by the following formulae.

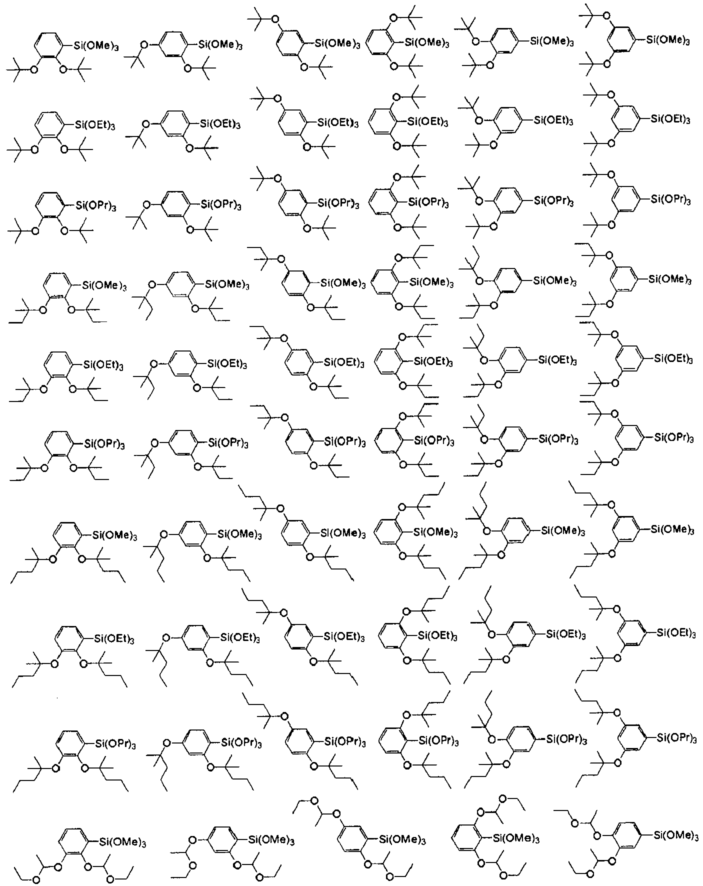

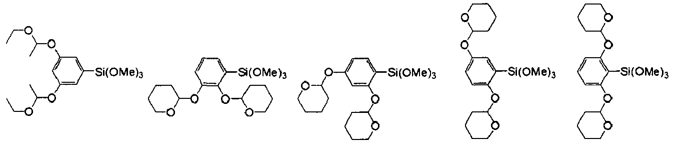

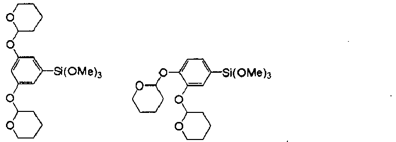

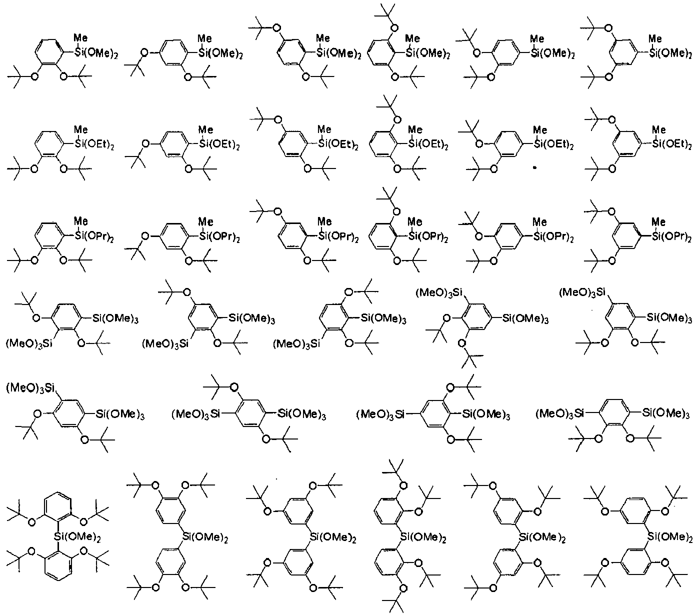

The present invention provides a silicon-containing compound at least one or more kinds of the repeating units represented by the following general formula (B), (C), (D), and (E), 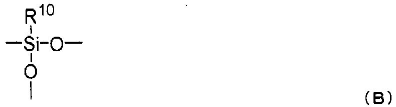 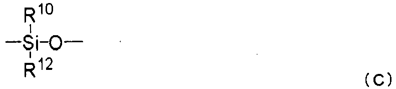 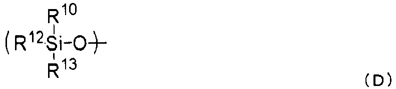 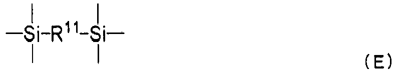 wherein, 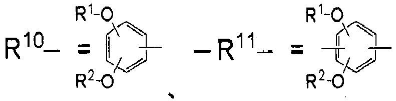 R¹ and R² represent an acid labile group. R¹² and R¹³ represent any of the R¹⁰, a hydrogen atom, or a monovalent organic group having 1 to 30 carbon atoms, and if either one of the two is R¹⁰, R¹²≠R¹³.

The silicon-containing compound of the present invention can be obtained by hydrolytic condensing a mixture containing the following hydrolyzable monomer in the silicon compound.

Illustrative example of the hydrolyzable monomer includes a tetramethoxysilane, a tetraethoxysilane, a tetrapropoxysilane, a tetraisopropoxysilane, a trimethoxysilane, a triethoxysilane, a tripropoxysilane, a triisopropoxysilane, a methyltrimethoxysilane, a methyltriethoxysilane, a methyltripropoxysilane, a methyltriisopropoxysilane, an ethyltrimethoxysilane, an ethyltriethoxysilane, an ethyltripropoxysilane, an ethyltriisopropoxysilane, a vinyltrimethoxysilane, a vinyltriethoxysilane, a vinyltripropoxysilane, a vinyltriisopropoxysilane, a propyltrimethoxysilane, a propyltriethoxysilane, a propyltripropoxysilane, a propyltriisopropoxysilane, an isopropyltrimethoxysilane, an isopropyltriethoxysilane, an isopropyltripropoxysilane, an isopropyltriisopropoxysilane, a butyltrimethoxysilane, a butyltriethoxysilane, a butyltripropoxysilane, a butyltriisopropoxysilane, a sec-butyltrimethoxysilane, a sec-butyltriethoxysilane, a sec-butyltripropoxysilane, a sec-butyltriisopropoxysilane, a t-butyltrimethoxysilane, a t-butyltriethoxysilane, a t-butyltripropoxysilane, a t-butyltriisopropoxysilane, a cyclopropyltrimethoxysilane, a cyclopropyltriethoxysilane, a cyclopropyltripropoxysilane, a cyclopropyltriisopropoxysilane, a cyclobutyl trimethoxysilane, a cyclobutyltriethoxysilane, a cyclobutyltripropoxysilane, a cyclobutyltriisopropoxysilane, a cyclopentyltrimethoxysilane, a cyclopentyltriethoxysilane, a cyclopentyltripropoxysilane, a cyclopentyltriisopropoxysilane, a cyclohexyltrimethoxysilane, a cyclohexyltriethoxysilane, a cyclohexyltripropoxysilane, a cyclohexyltriisopropoxysilane, a cyclohexenyltrimethoxysilane, a cyclohexenyltriethoxysilane, a cyclohexenyltripropoxysilane, a cyclohexenyltriisopropoxysilane, a cyclohexenylethyltrimethoxysilane, a cyclohexenylethyltriethoxysilane, a cyclohexenylethyltripropoxysilane, a cyclohexenylethyltriisopropoxysilane, a cyclooctyltrimethoxysilane, a cyclooctyltriethoxysilane, a cyclooctyltripropoxysilane, a cyclooctyltriisopropoxysilane, a cyclopentadienylpropyltrimethoxysilane, a cyclopentadienylpropyltriethoxysilane, a cyclopentadienylpropyltripropoxysilane, a cyclopentadienylpropyltriisopropoxysilane, a bicycloheptenyltrimethoxysilane, a bicycloheptenyltriethoxysilane, a bicycloheptenyltripropoxysilane, a bicycloheptenyltriisopropoxysilane, a bicycloheptyltrimethoxysilane, a bicycloheptyltriethoxysilane, a bicycloheptyltripropoxysilane, a bicycloheptyltriisopropoxysilane, an adamanthyltrimethoxysilane, an adamanthyltriethoxysilane, an adamanthyltripropoxysilane, an adamanthyltriisopropoxysilane, a phenyltrimethoxysilane, a phenyltriethoxysilane, a phenyltripropoxysilane, a phenyltriisopropoxysilane, a benzyltrimethoxysilane, a benzyltriethoxysilane, a benzyltripropoxysilane, a benzyltriisopropoxysilane, an anisyltrimethoxysilane, an anisyltriethoxysilane, an anisyltripropoxysilane, an anisyltriisopropoxysilane, a tolyltrimethoxysilane, a tolyltriethoxysilane, a tolyltripropoxysilane, a tolyltriisopropoxysilane, a phenethyltrimethoxysilane, a phenethyltriethoxysilane, a phenethyltripropoxysilane, a phenethyltriisopropoxysilane, a naphthyltrimethoxysilane, a naphthyltriethoxysilane, a naphthyltripropoxysilane, a naphthyltriisopropoxysilane, a dimethyldimethoxysilane, a dimethyldiethoxysilane, a methylethyldimethoxysilane, a methylethyldiethoxysilane, a dimethyldipropoxysilane, a dimethyldiisopropoxysilane, a diethyldimethoxysilane, a diethyldiethoxysilane, a diethyldipropoxysilane, a diethyldiisopropoxysilane, a dipropyldimethoxysilane, a dipropyldiethoxysilane, a dipropyldipropoxysilane, a dipropyldiisopropoxysilane, a diisopropyldimethoxysilane, a diisopropyldiethoxysilane, a diisopropyldipropoxysilane, a diisopropyldiisopropoxysilane, a dibutyldimethoxysilane, a dibutyldiethoxysilane, a dibutyldipropoxysilane, a dibutyldiisopropoxysilane, a di-sec-butyldimethoxysilane, a di-sec-butyldiethoxysilane, a di-sec-butyldipropoxysilane, a di-sec-butyldiisopropoxysilane, a di-t-butyldimethoxysilane, a di-t-butyldiethoxysilane, a di-t-butyldipropoxysilane, a di-t-butyldiisopropoxysilane, a dicyclopropyldimethoxysilane, a dicyclopropyldiethoxysilane, a dicyclopropyldipropoxysilane, a dicyclopropyldiisopropoxysilane, a dicyclobutyldimethoxysilane, a dicyclobutyldiethoxysilane, a dicyclobutyldipropoxysilane, a dicyclobutyldiisopropoxysilane, a dicyclopentyldimethoxysilane, a dicyclopentyldiethoxysilane, a dicyclopentyldipropoxysilane, a dicyclopentyldiisopropoxysilane, a dicyclohexyldimethoxysilane, a dicyclohexyldiethoxysilane, a dicyclohexyldipropoxysilane, a dicyclohexyldiisopropoxysilane, a dicyclohexenyldimethoxysilane, a dicyclohexenyldiethoxysilane, a dicyclohexenyldipropoxysilane, a dicyclohexenyldiisopropoxysilane, a dicyclohexenylethyldimethoxysilane, a dicyclohexenylethyldiethoxysilane, a dicyclohexenylethyldipropoxysilane, a dicyclohexenylethyldiisopropoxysilane, a dicyclooctyldimethoxysilane, a dicyclooctyldiethoxysilane, a dicyclooctyldipropoxysilane, a dicyclooctyldiisopropoxysilane, a dicyclopentadienylpropyldimethoxysilane, a dicyclopentadienylpropyldiethoxysilane, a dicyclopentadienylpropyldipropoxysilane, a dicyclopentadienylpropyldiisopropoxysilane, a bis(bicycloheptenyl) dimethoxysilane, a bis(bicycloheptenyl) diethoxysilane, a bis(bicycloheptenyl) dipropoxysilane, a bis(bicycloheptenyl) diisopropoxysilane, a bis(bicycloheptyl) dimethoxysilane, a bis(bicycloheptyl) diethoxysilane, a bis(bicycloheptyl) dipropoxysilane, a bis(bicycloheptyl) diisopropoxysilane, a diadamanthyldimethoxysilane, a diadamanthyldiethoxysilane, a diadamanthyldipropoxysilane, a diadamanthyldiisopropoxysilane, a diphenyldimethoxysilane, a diphenyldiethoxysilane, a methylphenyldimethoxysilane, a methylphenyldiethoxysilane, a diphenyldipropoxysilane, a diphenyldiisopropoxysilane, a trimethylmethoxysilane, a trimethylethoxysilane, a dimethylethylmethoxysilane, a dimethylethylethoxysilane, a dimethylphenylmethoxysilane, a dimethylphenylethoxysilane, a dimethylbenzylmethoxysilane, a dimethylbenzylethoxysilane, a dimethylphenethylmethoxysilane, and a dimethylphenethylethoxysilane.

Preferable example of the above hydrolyzable monomer includes a tetramethoxysilane, a tetraethoxysilane, a methyltrimethoxysilane, a methyltriethoxysilane, an ethyltrimethoxysilane, an ethyltriethoxysilane, a vinyltrimethoxysilane, a vinyltriethoxysilane, a propyltrimethoxysilane, a propyltriethoxysilane, an isopropyltrimethoxysilane, an isopropyltriethoxysilane, a butyltrimethoxysilane, a butyltriethoxysilane, an isobutyltrimethoxysilane, an isobutyltriethoxysilane, an allyltrimethoxysilane, an allyltriethoxysilane, a cyclopentyltrimethoxysilane, a cyclopentyltriethoxysilane, a cyclohexyltrimethoxysilane, a cyclohexyltriethoxysilane, a cyclohexenyltrimethoxysilane, a cyclohexenyltriethoxysilane, a phenyltrimethoxysilane, a phenyltriethoxysilane, a benzyltrimethoxysilane, a benzyltriethoxysilane, a tolyltrimethoxysilane, a tolyltriethoxysilane, an anisyltrimethoxysilane, an anisyltriethoxysilane, a phenethyltrimethoxysilane, a phenethyltriethoxysilane, a dimethyldimethoxysilane, a dimethyldiethoxysilane, a diethyldimethoxysilane, a diethyldiethoxysilane, a methylethyldimethoxysilane, a methylethyldiethoxysilane, a dipropyldimethoxysilane, a dibutyldimethoxysilane, a methylphenyldimethoxysilane, a methylphenyldiethoxysilane, a trimethylmethoxysilane, a dimethylethylmethoxysilane, a dimethylphenylmethoxysilane, a dimethylbenzylmethoxysilane, and a dimethylphenethylmethoxysilane.

The hydrolyzable metallic compound represented by the following general formula (1) can be used as a component of the silicon-containing compound,

U(OR⁷)ₘ₇ (OR⁸)ₘ₈ (1)

wherein, R⁷ and R⁸ represent an organic group having 1 to 30 carbon atoms, m7+m8 is the same as the valence depending on the kind of U, m7 and m8 are an integer of 0 or more, U represents an element from group III, group IV, or group V in the periodic table except for carbon and silicon.

Illustrative example of the hydrolyzable metallic compound (1) used includes the following compounds. If U represents a boron, illustrative example of the compound represented by the above general formula (1) includes a boron methoxide, a boron ethoxide, a boron propoxide, a boron butoxide, a boron amyloxide, a boron hexyloxide, a boron cyclopentoxide, a boron cyclohexyloxide, a boron allyloxide, a boron phenoxide, a boron methoxyethoxide, a boric acid, and a boron oxide as a monomer.

If U represents an aluminum, illustrative example of the compound represented by the general formula (1) includes an aluminum methoxide, an aluminum ethoxide, an aluminum propoxide, an aluminum butoxide, an aluminum amyloxide, an aluminum hexyloxide, an aluminum cyclopentoxide, an aluminum cyclohexyloxide, an aluminum allyloxide, an aluminum phenoxide, an aluminum methoxyethoxide, an aluminum ethoxyethoxide, an aluminum dipropoxyethyl acetoacetate, an aluminum dibutoxyethyl acetoacetate, an aluminum propoxy bisethyl acetoacetate, an aluminum butoxy bisethyl acetoacetate, an aluminum 2,4-pentanedionate, and an aluminum 2,2,6,6-tetramethyl-3,5-heptanedionate as a monomer.

If U represents a gallium, illustrative example of the compound represented by the general formula (1) includes a gallium methoxide, a gallium ethoxide, a gallium propoxide, a gallium butoxide, a gallium amyloxide, a gallium hexyloxide, a gallium cyclopentoxide, a gallium cyclohexyloxide, a gallium allyloxide, a gallium phenoxide, a gallium methoxyethoxide, a gallium ethoxyethoxide, a gallium dipropoxyethyl acetoacetate, a gallium dibutoxyethyl acetoacetate, a gallium propoxy bisethyl acetoacetate, a gallium butoxy bisethyl acetoacetate, a gallium 2,4-pentanedionate, and a gallium 2,2,6,6-tetramethyl-3,5-heptanedionate as a monomer.

If U represents a yttrium, illustrative example of the compound represented by the general formula (1) includes a yttrium methoxide, a yttrium ethoxide, a yttrium propoxide, a yttrium butoxide, a yttrium amyloxide, a yttrium hexyloxide, a yttrium cyclopentoxide, a yttrium cyclohexyloxide, a yttrium allyloxide, a yttrium phenoxide, a yttrium methoxyethoxide, a yttrium ethoxyethoxide, a yttrium dipropoxyethyl acetoacetate, a yttrium dibutoxyethyl acetoacetate, a yttrium propoxy bisethyl acetoacetate, a yttrium butoxy bisethyl acetoacetate, a yttrium 2,4-pentanedionate, and a yttrium 2,2,6,6-tetramethyl-3,5-heptanedionate as a monomer.

If U represents a germanium, illustrative example of the compound represented by the general formula (1) includes a germanium methoxide, a germanium ethoxide, a germanium propoxide, a germanium butoxide, a germanium amyloxide, a germanium hexyloxide, a germanium cyclopentoxide, a germanium cyclohexyloxide, a germanium allyloxide, a germanium phenoxide, a germanium methoxyethoxide, and a germanium ethoxyethoxide as a monomer.

If U represents a titanium, illustrative example of the compound represented by the general formula (1) includes a titanium methoxide, a titanium ethoxide, a titanium propoxide, a titanium butoxide, a titanium amyloxide, a titanium hexyloxide, a titanium cyclopentoxide, a titanium cyclohexyloxide, a titanium allyloxide, a titanium phenoxide, a titanium methoxyethoxide, a titanium ethoxyethoxide, a titanium dipropoxy bisethyl acetoacetate, a titanium dibutoxy bisethyl acetoacetate, a titanium dipropoxy bis2,4-pentanedionate, and a titanium dibutoxy bis2,4-pentanedionate as a monomer.

If U represents a hafnium, illustrative example of the compound represented by the general formula (1) includes a hafnium methoxide, a hafnium ethoxide, a hafnium propoxide, a hafnium butoxide, a hafnium amyloxide, a hafnium hexyloxide, a hafnium cyclopentoxide, a hafnium cyclohexyloxide, a hafnium allyloxide, a hafnium phenoxide, a hafnium methoxyethoxide, a hafnium ethoxyethoxide, a hafnium dipropoxy bisethyl acetoacetate, a hafnium dibutoxy bisethyl acetoacetate, a hafnium dipropoxy bis2,4-pentanedionate, and a hafnium dibutoxy bis2,4-pentanedionate as a monomer.

If U represents a tin, illustrative example of the compound represented by the general formula (1) includes a methoxy tin, an ethoxy tin, a propoxy tin, a butoxy tin, a phenoxy tin, a methoxyethoxy tin, an ethoxyethoxy tin, a tin 2,4-pentanedionate, and a tin 2,2,6,6-tetramethyl-3,5-heptanedionate as a monomer.

If U represents an arsenic, illustrative example of the compound represented by the general formula (1) include a methoxy arsenic, an ethoxy arsenic, a propoxy arsenic, a butoxy arsenic, and a phenoxy arsenic as a monomer.

If U represents an antimony, illustrative example of the compound represented by the general formula (1) includes a methoxy antimony, an ethoxy antimony, a propoxy antimony, a butoxy antimony, a phenoxy antimony, an antimony acetate, and an antimony propionate as a monomer.

If U represents a niobium, illustrative example of the compound represented by the general formula (1) includes a methoxy niobium, an ethoxy niobium, a propoxy niobium, a butoxy niobium, and a phenoxy niobium as a monomer.

If U represents a tantalum, illustrative example of the compound represented by the general formula (1) includes a methoxy tantalum, an ethoxy tantalum, a propoxy tantalum, a butoxy tantalum, and a phenoxy tantalum as a monomer.

If U represents a bismuth, illustrative example of the compound represented by the general formula (1) includes a methoxy bismuth, an ethoxy bismuth, a propoxy bismuth, a butoxy bismuth, and a phenoxy bismuth as a monomer.

If U represents a phosphorus, illustrative example of the compound represented by the general formula (1) includes a trimethyl phosphate, a triethyl phosphate, a tripropyl phosphate, a trimethyl phosphite, a triethyl phosphite, a tripropyl phosphite, and a diphosphorus pentoxide as a monomer.

If U represents a vanadium, illustrative example of the compound represented by the general formula (1) includes a vanadium oxidebis(2,4-pentanedionate), a vanadium 2,4-pentanedionate, a vanadium tributoxideoxide, and a vanadium tripropoxideoxide as a monomer.

If U represents a zirconium, illustrative example of the compound represented by the general formula (1) includes a methoxy zirconium, an ethoxy zirconium, a propoxy zirconium, a butoxy zirconium, a phenoxy zirconium, a zirconium dibutoxidebis(2,4-pentanedionate), and a zirconium dipropoxidebis(2,2,6,6-tetramethyl-3,5-heptanedionate) as a monomer.

### Synthesis method of silicon-containing compound

### Synthesis method 1: Acid catalyst

The silicon-containing compound of the present invention can be obtained by hydrolytic condensing the silicon compound of the present invention, the above hydrolyzable monomer or hydrolyzable metallic compound in the presence of an acid catalyst.

Illustrative example of the acid catalyst used includes an organic acid such as a formic acid, an acetic acid, an oxalic acid, and a maleic acid; a fluorinated acid, a hydrochloric acid, a hydrobromic acid, a sulfuric acid, a nitric acid, a perchloric acid, a phosphoric acid, a methanesulfonic acid, a benzenesulfonic acid, and a toluenesulfonic acid. The catalyst is used in the range of 1×10⁻⁶ to 10 mole, preferably 1×10⁻⁵ to 5 mole, and more preferably 1×10⁻⁴ to 1 mole, per mole of a monomer.

The amount of water for obtaining a silicon-containing compound by hydrolytic condensing these monomers is preferably added in the range of 0.01 to 100 mole, more preferably 0.05 to 50 mole, and much more preferably 0.1 to 30 mole, per mole of a hydrolyzable substituent linked to a monomer. If the amount is less than 100 mole, a reaction device becomes smaller and more economical.

In operation, a monomer is added to a catalyst aqueous solution to start hydrolytic condensation reaction. An organic solvent may be added to the catalyst aqueous solution, and a monomer may be diluted with the organic solvent, or both may be performed. The reaction temperature is in the range of 0 to 100°C, and preferably 5 to 80°C. The reaction temperature is maintained in the range of 5 to 80°C when a monomer is dropped, and then the mixture is preferably aged in the range of 20 to 80°C.

Preferable example of the organic solvent that can be added to a catalyst aqueous solution or can dilute a monomer includes a methanol, an ethanol, a 1-propanol, a 2-propanol-1-butanol, a 2-butanol, a 2-methyl-1-propanol, an acetone, an acetonitrile, a tetrahydrofuran, a toluene, a hexane, an ethyl acetate, an acetone, a methylethyl ketone, a methylisobutyl ketone, a cyclohexanone, a methyl amyl ketone, a butanediol monomethyl ether, a propylene glycolmonomethyl ether, an ethylene glycolmonomethyl ether, a butanediol monoethylether, a propylene glycol monoethylether, an ethylene glycol monoethylether, a propylene glycoldimethyl ether, a diethylene glycoldimethyl ether, a propylene glycolmonomethyl ether acetate, a propylene glycol monoethylether acetate, an ethyl pyruvate, a butyl acetate, a 3-methoxy methyl propionate, a 3-ethoxy ethyl propionate, an tert-butyl acetate, a t-butyl propionate, a propylene glycol mono-t-butylether acetate, a γ-butyrolactone, an acetonitrile, a tetrahydrofuran and a mixture thereof.

Preferable example of these solvents includes a water-soluble solvent, e.g., an alcohol such as a methanol, an ethanol, a 1-propanol, a 2-propanol; a polyvalent alcohol such as an ethylene glycol a propylene glycol; a polyvalent alcohol condensate derivative such as a butanediol monomethyl ether, a propylene glycolmonomethyl ether, an ethylene glycolmonomethyl ether, a butanediol monoethylether, a propylene glycol monoethylether, an ethylene glycol monoethylether, a butanediol monopropylether, a propylene glycol monopropylether, an ethylene glycol monopropylether; an acetone, an acetonitrile, and a tetrahydrofuran. Particularly preferable is a solvent with a boiling point of 100°C or less.

The amount of the organic solvent used is in the range of 0 to 1,000ml, and particularly preferable 0 to 500ml, per mole of a monomer. A smaller amount of the organic solvent used can make a reaction container smaller and more economical.

Then, a catalyst is subjected to neutralization reaction as required to obtain a reaction mixture aqueous solution. The amount of an alkaline substance to be used for neutralization is preferably 0.1 to 2 equivalent weight, relative to an acid used in the catalyst. The alkaline substance may be optionally selected if it is alkaline in water.

Subsequently, it is preferable that a by-product such as an alcohol produced by hydrolytic condensation reaction from the reaction mixture be removed under reduced pressure. The temperature for heating the reaction mixture is preferably in the range of 0 to 100°C, more preferably 10 to 90°C, and much more preferably 15 to 80°C, depending on the kind of an alcohol generated by reaction with an organic solvent added. The decompression degree is preferably less than atmospheric pressure, more preferably less than 80kPa under absolute pressure, and much more preferably less than 50kPa under absolute pressure, depending on kinds of an organic solvent to be removed and an alcohol, ventilation, condensing apparatus and heating temperature. Despite a difficulty of exactly learning the amount of the alcohol to be removed, about more than 80% by mass of the alcohol generated is preferably removed.

Next, the acid catalyst used in hydrolytic condensation reaction may be removed from the reaction mixture. A method for removing an acid catalyst is to mix water and a reaction mixture and extract a silicon-containing compound with an organic solvent. Preferable example of the organic solvent used includes the one that can dissolve a silicon-containing compound and achieve two-layer separation by mixing with water. Specific example thereof includes a methanol, an ethanol, a 1-propanol, a 2-propanol, a 1-butanol, a 2-butanol, a 2-methyl-1-propanol, an acetone, a tetrahydrofuran, a toluene, a hexane, an ethyl acetate, an acetone, a cyclohexanone, a methyl amyl ketone, a butanediol monomethyl ether, a propylene glycolmonomethyl ether, an ethylene glycolmonomethyl ether, a butanediol monoethylether, a propylene glycol monoethylether, an ethylene glycol monoethylether, a butanediol monopropylether, a propylene glycol monopropylether, an ethylene glycol monopropylether, a propylene glycoldimethyl ether, a diethylene glycoldimethyl ether, a propylene glycolmonomethyl ether acetate, a propylene glycol monoethylether acetate, an ethyl pyruvate, a butyl acetate, a 3-methoxy methyl propionate, a 3-ethoxy ethyl propionate, an t-butyl acetate, a t-butyl propionate, a propylene glycol mono-t-butylether acetate, a γ-butyrolactone, a methylisobutyl ketone, a cyclopentylmethylether, a tetrahydrofuran, and a mixture thereof.

Moreover, a mixture of a water-soluble organic solvent and a poorly water soluble organic solvent can be used. Preferable example thereof includes a methanol ethyl acetate mixture, an ethanol ethyl acetate mixture, a 1-propanol ethyl acetate mixture, a 2-propanol ethyl acetate mixture, a butanediol monomethyl ether ethyl acetate mixture, a propylene glycolmonomethyl ether ethyl acetate mixture, an ethylene glycolmonomethyl ether ethyl acetate mixture, a butanediol monoethylether ethyl acetate mixture, a propylene glycol monoethylether ethyl acetate mixture, an ethylene glycol monoethylether ethyl acetate mixture, a butanediol monopropylether ethyl acetate mixture, a propylene glycol monopropylether ethyl acetate mixture, an ethylene glycol monopropylether ethyl acetate mixture, a methanol methylisobutyl ketone mixture, an ethanol methylisobutyl ketone mixture, a 1-propanol methylisobutyl ketone mixture, a 2-propanol methylisobutyl ketone mixture, a propylene glycolmonomethyl ether methylisobutyl ketone mixture, an ethylene glycolmonomethyl ether methylisobutyl ketone mixture, a propylene glycol monoethylether methylisobutyl ketone mixture, an ethylene glycol monoethylether methylisobutyl ketone mixture, a propylene glycol monopropylether methylisobutyl ketone mixture, an ethylene glycol monopropylether methylisobutyl ketone mixture, a methanol cyclopentylmethylether mixture, an ethanol cyclopentylmethylether mixture, a 1-propanol cyclopentylmethylether mixture, a 2-propanol cyclopentylmethylether mixture, a propylene glycolmonomethyl ether cyclopentylmethylether mixture, an ethylene glycolmonomethyl ether cyclopentylmethylether mixture, a propylene glycol monoethylether cyclopentylmethylether mixture, an ethylene glycol monoethylether cyclopentylmethylether mixture, a propylene glycol monopropylether cyclopentylmethylether mixture, an ethylene glycol monopropylether cyclopentylmethylether mixture, a methanol propylene glycolmethyl ether acetate mixture, an ethanol propylene glycolmethyl ether acetate mixture, a 1-propanol propylene glycolmethyl ether acetate mixture, a 2-propanol propylene glycolmethyl ether acetate mixture, a propylene glycolmonomethyl ether propylene glycolmethyl ether acetate mixture, an ethylene glycolmonomethyl ether propylene glycolmethyl ether acetate mixture, a propylene glycol monoethylether propylene glycolmethyl ether acetate mixture, an ethylene glycol monoethylether propylene glycolmethyl ether acetate mixture, a propylene glycol monopropylether propylene glycolmethyl ether acetate mixture, and an ethylene glycol monopropylether propylene glycolmethyl ether acetate mixture, but is not restricted to a combination thereof.

The mixing ratio of the water-soluble organic solvent and the poorly water soluble organic solvent is determined accordingly. However, the water-soluble organic solvent is 0.1 to 1,000 parts by mass, preferably 1 to 500 parts by mass, and much more preferably 2 to 100 parts by mass, relative to a poorly water soluble organic solvent (100 parts by mass).

Subsequently, the silicon-containing compound solution may be washed with neutral water. The neutral water may be deionized water or ultrapure water. The amount of the water is 0.01 to 100L, preferably 0.05 to 50L, and more preferably 0.1 to 5L, per liter of a silicon-containing compound solution. The method for washing the mixture is to charge both solutions into the same container, agitate them and then allow them to stand to separate water layer. The number of washing may be once or more, but preferably once to 5 times because 10 or more washing is not effective.

Other methods for removing an acid catalyst include a method by ion-exchange resin, and a method for removing an acid catalyst after neutralization with an epoxy compound such as an ethylene oxide and a propylene oxide. These methods can be selected according to the kind of an acid catalyst used in the reaction.

The water washing can allow part of a silicon-containing compound to move to and blend into a water layer, leading to fractionation effect. Therefore, the number of washing and the amount of washing water may be accordingly selected in view of catalyst-removing and fractionation effects.

As to both a silicon-containing compound having a residual acid catalyst and a silicon-containing compound solution having no more acid catalyst, a last solvent is added thereto and solvent is exchanged under reduced pressure to obtain a desired silicon-containing compound solution. The temperature for solvent exchange is preferably in the range of 0 to 100°C, more preferably 10 to 90°C, and much more preferably 15 to 80°C, depending on the kinds of a reaction solvent to be removed and an extracting solvent. The decompression degree is preferably less than atmospheric pressure, more preferably less than 80kPa under absolute pressure, and much more preferably less than 50kPa under absolute pressure, depending on the kind of an extracting solvent, ventilation, a condensing apparatus, and heating temperature.

Accordingly, change in a solvent may be instable the silicon-containing compound. In order to prevent this instability that is caused due to chemical affinity of the last solvent and the silicon-containing compound, a monovalent, a divalent, or a more polyvalent alcohol having a cyclic ether as a substituent described in Japanese Unexamined Patent Publication No. 2009-126940 (paragraphs (0181) to (0182)) may be added thereto as a stabilizer. The amount to be added is in the range of 0 to 25 parts by mass, preferably 0 to 15 parts by mass, and more preferably 0 to 5 parts by mass, relative to 100 parts by mass of a silicon-containing compound in a solution before solvent exchange, but more than 0.5 parts by mass if an alcohol is most preferable. A monovalent, a divalent, or a more polyvalent alcohol having a cyclic ether as a substituent may be added to a solution, as required, to perform solvent exchange.

If a silicon-containing compound is concentrated with more than a certain level of concentration, condensation reaction will further proceed, so that it cannot be redissoluted in an organic solvent. Therefore, the concentration is preferably maintained at a proper level. If the concentration is too low to the contrary, the amount of a solvent is too large, thus a proper solution concentration is preferable in view of an economical advantage. The concentration is preferably in the range of 0.1 to 20% by mass.

Preferable example of the last solvent added to a silicon-containing compound includes an alcohol solvent, and particularly a monoalkyl ether derivative such as an ethylene glycol, a diethylene glycol, a triethylene glycol, a propylene glycol, a dipropylene glycol, and a butanediol. Specific example thereof includes a butanediol monomethyl ether, a propylene glycolmonomethyl ether, an ethylene glycolmonomethyl ether, a butanediol monoethylether, a propylene glycol monoethylether, an ethylene glycol monoethylether, a butanediol monopropylether, a propylene glycol monopropylether, and an ethylene glycol monopropylether.

With these solvents as a main component, a non-alcohol solvent can be added as a co-solvent. Illustrative example of the co-solvent includes an acetone, a tetrahydrofuran, a toluene, a hexane, an ethyl acetate, a cyclohexanone, a methyl amyl ketone, a propylene glycoldimethyl ether, a diethylene glycoldimethyl ether, a propylene glycolmonomethyl ether acetate, a propylene glycol monoethylether acetate, an ethyl pyruvate, a butyl acetate, a 3-methoxy methyl propionate, a 3-ethoxy ethyl propionate, a t-butyl acetate, a t-butyl propionate, a propylene glycol mono-t-butylether acetate, a γ-butyrolactone, a methylisobutyl ketone, and a cyclopentylmethylether.

In another operation by using an acid catalyst, water or a water-containing organic solvent is added to a monomer or an organic solution of a monomer to start hydrolysis reaction. The catalyst may be added to a monomer or an organic solution of a monomer or added to water or a water-containing organic solvent. The reaction temperature is in the range of 0 to 100°C, and preferably 10 to 80°C. A method for heating a mixture at 10 to 50°C when water is dropped and then heating the mixture at 20 to 80°C to age the mixture is preferable.

Preferable example of the organic solvent includes water-soluble solvent, e.g. a polyvalent alcohol condensate derivative such as a methanol, an ethanol, a 1-propanol, a 2-propanol, a 1-butanol, a 2-butanol, a 2-methyl-1-propanol, an acetone, a tetrahydrofuran, an acetonitrile, a butanediol monomethyl ether, a propylene glycolmonomethyl ether, an ethylene glycolmonomethyl ether, a butanediol monoethylether, a propylene glycol monoethylether, an ethylene glycol monoethylether, a butanediol monopropylether, a propylene glycol monopropylether, an ethylene glycol monopropylether, a propylene glycoldimethyl ether, a diethylene glycoldimethyl ether acetate, a propylene glycolmonomethyl ether acetate, a propylene glycol monoethylether acetate, and a propylene glycol monopropylether, and a mixture thereof.

The amount of the organic solvent used is in the range of 0 to 1,000ml, particularly preferably 0 to 500ml, per mole of a monomer. A smaller amount of the organic solvent used can make a reaction container smaller and more economical. A reaction mixture obtained is post-treated like the method to obtain a silicon-containing compound.

### Synthesis method 2: Alkali catalyst

The silicon-containing compound can be obtained by hydrolytic condensing a monomer in the presence of an alkali catalyst. Illustrative example of the alkali catalyst used includes a methylamine, an ethylamine, a propylamine, a butylamine, an ethylenediamine, a hexamethylene diamine, a dimethylamine, a diethylamine, an ethylmethylamine, a trimethylamine, a triethylamine, a tripropylamine, a tributylamine, a cyclohexylamine, a dicyclohexylamine, a monoethanolamine, a diethanolamine, a dimethyl monoethanolamine, a monomethyl diethanolamine, a triethanolamine, a diazabicyclo octane, a diazabicyclo cyclononene, a diazabicyclo undecene, a hexamethylene tetraamine, an aniline, an N,N-dimethylaniline, a pyridine, an N,N-dimethylaminopyridine, a pyrrole, a piperazine, a pyrrolidine, a piperidine, a picoline, a tetramethylammonium hydroxide, a choline hydroxide, a tetrapropylammonium hydroxide, a tetrabutylammonium hydroxide, an ammonia, a lithium hydroxide, a sodium hydroxide, a potassium hydroxide, a barium hydroxide, and a calcium hydroxide. The amount of the catalyst used is in the range of 1×10⁻⁶ mole to 10 mole, preferably 1×10⁻⁵ mole to 5 mole, and more preferably 1×10⁻⁴ mole to 1 mole, per mole of a silicon monomer.

The amount of water for obtaining a silicon-containing compound by hydrolytic condensing the above monomer is preferably in the range of 0.1 to 50 mole to be added, per mole of a hydrolyzable substituent bonded to the monomer. If the amount is less than 50 mole, a reaction device becomes smaller and more economical.

In operation, a monomer is added to a catalyst solution to start hydrolytic condensation reaction. An organic solvent may be added to a catalyst solution, a monomer may be diluted with an organic solvent, or both may be performed. The reaction temperature is in the range of 0 to 100°C, and preferably 5 to 80°C. A method for maintaining the temperature at 5 to 80°C when a monomer is dropped and then aging the mixture at 20 to 80°C is preferable.

The organic solvent used that can be added to an alkali catalyst solution or can dilute a monomer is preferably an illustrative example of the organic solvent that can be added to an acid catalyst solution. The amount of the organic solvent used is preferably in the range of 0 to 1,000ml, per mole of a monomer, due to economical reaction.

As required, a catalyst is subjected to neutralization reaction afterward to obtain a reaction mixture aqueous solution. The amount of an acid material used for neutralization is preferably in the range of 0.1 to 2 equivalent weight, relative to an alkaline substance used in the catalyst. The acid material may be optionally selected if it is acid in water.

Subsequently, it is preferable that a by-product such as an alcohol produced by hydrolytic condensation reaction from the reaction mixture be removed under reduced pressure. The temperature for heating the reaction mixture is preferably in the range of 0 to 100°C, more preferably 10 to 90°C, and much more preferably 15 to 80°C, depending on the kind of an alcohol generated by reaction with an organic solvent added. The decompression degree is preferably less than atmospheric pressure, more preferably less than 80kPa under absolute pressure, and much more preferably less than 50kPa under absolute pressure, depending on kinds of an organic solvent to be removed and an alcohol, ventilation, condensing apparatus and heating temperature. Despite a difficulty of exactly learning the amount of the alcohol to be removed, about more than 80% by mass of the alcohol generated is preferably removed.

Next, to remove the alkali catalyst used in hydrolytic condensation reaction, a silicon-containing compound is extracted with an organic solvent. The organic solvent used can preferably dissolve a silicon-containing compound and achieve two-layer separation by mixing with water. Moreover, a mixture of a water-soluble organic solvent and a poorly water soluble organic solvent can be used.

Illustrative example of the organic solvent used for removing an alkali catalyst includes the above-mentioned organic solvent for removing the acid catalyst, and a mixture of a water-soluble organic solvent and poorly water soluble organic solvent.

The mixing ratio of the water-soluble organic solvent and the poorly water soluble organic solvent is determined accordingly. However, the water-soluble organic solvent is 0.1 to 1,000 parts by mass, preferably 1 to 500 parts by mass, and much more preferably 2 to 100 parts by mass, relative to a poorly water soluble organic solvent (100 parts by mass).

Subsequently, the silicon-containing compound solution may be washed with neutral water. The neutral water may be deionized water or ultrapure water. The amount of the water is 0.01 to 100L, preferably 0.05 to 50L, and more preferably 0.1 to 5L, per liter of a silicon-containing compound solution. The method for washing the mixture is to charge both solutions into the same container, agitate them and then allow them to stand to separate water layer. The number of washing may be once or more, but preferably once to 5 times because 10 or more washing is not effective.

A last solvent is added to a washed silicon-containing compound solution and solvent is exchanged under reduced pressure to obtain a desired silicon-containing compound solution. The temperature for solvent exchange is preferably in the range of 0 to 100°C, more preferably 10 to 90°C, and much more preferably 15 to 80°C, depending on the kinds of a reaction solvent to be removed and an extracting solvent. The decompression degree is preferably less than atmospheric pressure, more preferably less than 80kPa under absolute pressure, and much more preferably less than 50kPa under absolute pressure, depending on the kind of an extracting solvent, ventilation, a condensing apparatus, and heating temperature.

Preferable example of the last solvent added to a silicon-containing compound includes an alcohol solvent, and particularly a monoalkyl ether such as an ethylene glycol, a diethylene glycol, a triethylene glycol; and a monoalkyl ether such as a propylene glycol, a dipropylene glycol. Specific preferable example thereof includes a propylene glycolmonomethyl ether, an ethylene glycolmonomethyl ether, a propylene glycol monoethylether, an ethylene glycol monoethylether, a propylene glycol monopropylether, and an ethylene glycol monopropylether.

In another operation by using an alkali catalyst, water or a water-containing organic solvent is added to a monomer or an organic solution of a monomer to start hydrolysis reaction. The catalyst may be added to a monomer or an organic solution of a monomer or added to water or a water-containing organic solvent. The reaction temperature is in the range of 0 to 100°C, and preferably 10 to 80°C. A method for heating a mixture at 10 to 50°C when water is dropped and then heating the mixture at 20 to 80°C to age the mixture is preferable.

Illustrative example of the organic solvent that can be used as an organic solution of a monomer or a water-containing organic solvent includes a water-soluble solvent, e.g. a polyvalent alcohol condensate derivative such as a methanol, an ethanol, a 1-propanol, a 2-propanol, a 1-butanol, a 2-butanol, a 2-methyl-1-propanol, an acetone, a tetrahydrofuran, an acetonitrile, a propylene glycolmonomethyl ether, an ethylene glycolmonomethyl ether, a propylene glycol monoethylether, an ethylene glycol monoethylether, a propylene glycol monopropylether, an ethylene glycol monopropylether, a propylene glycoldimethyl ether, a diethylene glycoldimethyl ether, a propylene glycolmonomethyl ether acetate, a propylene glycol monoethylether acetate, and a propylene glycol monopropylether, and a mixture thereof.

The molecular weight of the silicon-containing compound obtained in the above Synthesis method 1 or 2 can be adjusted not only by selecting a monomer, but also controlling reaction conditions during polymerization. However, if the average molecular weight exceeds 100,000, the silicon-containing compound could show a foreign object and coating spot. It is thus preferable that the molecular weight be less than 100,000, more preferably 200 to 50,000, and much more preferably 300 to 30,000. The above average molecular weight is obtained as data, in terms of polystyrene as a reference material, by means of gel-permeation chromatography (GPC) by using RI as a detector and tetrahydrofuran as an eluent.

The polysiloxane contained in the resist underlayer film composition comprising the silicon-containing compound of the present invention and other solvents can be obtained with the hydrolyzable monomer as the acid or alkali catalyst.

### Thermal crosslinking accelerator

In the present invention, a thermal crosslinking accelerator may be blended into a silicon-containing composition for forming a resist underlayer film. Illustrative example of the thermal crosslinking accelerator to be blended includes a compound represented by the following general formula (2) or (3). Specifically, a material described in Patent Document 6 can be added,

LₐH_{b}X (2)

wherein, L represents a lithium, a sodium, a potassium, a rubidium, or a cesium, X represents a hydroxyl group, or a monovalent, a divalent or a polyvalent organic acid group having 1 to 30 carbon atoms, a is an integer of 1 or more, b is an integer of 0 or 1 or more, and a+b is a valence of a hydroxyl group or an organic acid group,

MY (3)

wherein, M represents a sulfonium, an iodonium, or an ammonium, and Y represents a non-nucleophilic counterion.

The above thermal crosslinking accelerator can be used alone or in combination with two or more kinds thereof. The amount of the thermal crosslinking accelerator to be added is preferably in the range of 0.01 to 50 parts by mass, more preferably 0.1 to 40 parts by mass, relative to 100 parts by mass of a polysiloxane as a base polymer.

### Organic acid

To improve the stability of the silicon-containing composition for forming a resist underlayer film of the present invention, a monovalent, a divalent, or a polyvalent organic acid having 1 to 30 carbon atoms is preferably added. Illustrative example of the organic acid to be added includes a formic acid, an acetic acid, a propionic acid, a butanoic acid, a pentanoic acid, a hexanoic acid, a heptanoic acid, an octanoic acid, a nonanoic acid, a decanoic acid, an oleic acid, a stearic acid, a linoleic acid, a linolenic acid, a benzoic acid, a phthalic acid, an isophthalic acid, a terephthalic acid, a salicylic acid, a trifluoroacetic acid, a monochloracetic acid, a dichloracetic acid, a trichloroacetic acid, an oxalic acid, a malonic acid, a methyl malonate, an ethyl malonate, a propyl malonate, a butyl malonate, a dimethyl malonate, a diethyl malonate, a succinic acid, a methyl succinate, a glutaric acid, an adipic acid, an itaconic acid, a maleic acid, a fumaric acid, a citraconic acid, and a citric acid, and particularly preferable are an oxalic acid, a maleic acid, a formic acid, an acetic acid, a propionic acid, and a citric acid. To maintain the stability, two or more kinds of acids may be mixed. The amount of the acid to be added is in the range of 0.001 to 25 parts by mass, preferably 0.01 to 15 parts by mass, and more preferably 0.1 to 5 parts by mass, relative to 100 parts by mass of a silicon contained in the composition.

The above organic acid may be blended in terms of composition pH, preferably in the range of 0≤pH≤7, more preferably 0.3≤pH≤6.5, and much more preferably 0.5≤pH≤6.

### Water

In the present invention, water may be added to the composition. Water addition hydrates a polysiloxane compound in the composition to improve lithography performance. The water content in the solvent component of the composition is more than 0% by mass and less than 50% by mass, more preferably 0.3 to 30% by mass, and much more preferably 0.5 to 20% by mass. Each component, if added in large volumes, can worsen the uniformity of the silicon-containing resist underlayer film, resulting in eye hole at worst. On the other hand, if added in small volumes, lithography performance could be reduced.

The amount of all solvents containing water used is 100 to 100,000 parts by mass, particularly preferable 200 to 50,000 parts by mass, relative to 100 parts by mass of a polysiloxane compound as a base polymer.

### Photoacid generator

In the present invention, a photoacid generator may be added to a composition. Illustrative example of the photoacid generator used in the present invention includes a material described in Japanese Unexamined Patent Publication No. 2009-126940 (paragraphs (0160) to (0179)).

### Stabilizer

Moreover, in the present invention, a stabilizer may be added to a composition. A monovalent, a divalent, or a polyvalent alcohol having a cyclic ether as a substituent can be added as a stabilizer. If a stabilizer described in Japanese Unexamined Patent Publication No. 2009-126940 (paragraphs (0181) to (0182)) is added, the stability of the silicon-containing composition for forming a resist underlayer film can be improved.

### Surfactant

Furthermore, in the present invention, a surfactant can be blended into a composition as required, specifically a material described in Japanese Unexamined Patent Publication No. 2009-126940 (paragraph (0185)).

### Other components

In addition, in the present invention, a high-boiling point solvent (boiling point: 180 degree or higher) can be added to a composition as required. Illustrative example of the high-boiling point solvent includes a 1-octanol, a 2-ethyl hexanol, a 1-nonanol, a 1-decanol, a 1-undecanol, an ethylene glycol, a 1,2-propylene glycol, a 1,3-butylene glycol, a 2,4-pentanediol, a 2-methyl-2,4-pentanediol, a 2,5-hexanediol, a 2,4-heptanediol, a 2-ethyl-1,3-hexanediol, a diethylene glycol, a dipropylene glycol, a triethylene glycol, a tripropylene glycol, a glycerin, an n-nonyl acetate, an acetic acid ethylene glycol monoethylether, a 1,2-diacetoxyethane, a 1-acetoxy-2-methoxyethane, a 1,2-diacetoxy propane, a diethylene glycolmonomethyl ether acetate, a diethylene glycol monoethylether acetate, a diethylene glycol monon-butylether acetate, a propyl acetateene glycolmonomethyl ether, a propyl acetateene glycol monopropylether, a propyl acetateene glycol monobutylether, a dipropylene glycolmonomethyl ether acetate, and a dipropylene glycol monoethylether acetate.

### Negative patterning process

### Negative patterning process 1

The present invention provides a patterning process comprising a step of forming an organic underlayer film on a body to be processed by using an application-type composition for organic underlayer film; a step of forming a silicon-containing resist underlayer film on the organic underlayer film by using the silicon-containing composition for forming a resist underlayer film; a step of forming a photoresist film on the silicon-containing resist underlayer film by using a chemically-amplified resist composition; a step of, after a heat-treatment, forming a negative pattern by exposure of the photoresist film by a high energy radiation and by dissolution of a non-exposed area of the photoresist film by using a developer of an organic solvent; a step of transferring the pattern on the silicon-containing resist underlayer film by dry etching with the photoresist film having the formed negative pattern as a mask; a step of transferring the pattern on the organic underlayer film by dry etching with the silicon-containing resist underlayer film having the transferred pattern as a mask; and a step of further transferring the pattern on the body to be processed by dry etching with the organic underlayer film having the transferred pattern as a mask (i.e. "multilayer resist method").

### Negative patterning process 2

The present invention provides a patterning process comprising a step of forming an organic hard mask mainly comprising carbon on a body to be processed by CVD method; a step of forming a silicon-containing resist underlayer film on the organic hard mask by using the silicon-containing composition for forming a resist underlayer film; a step of forming a photoresist film on the silicon-containing resist underlayer film by using a chemically-amplified resist composition; a step of, after a heat-treatment, forming a negative pattern by exposure of the photoresist film by a high energy radiation and by dissolution of a non-exposed area of the photoresist film by using a developer of an organic solvent; a step of transferring the pattern on the silicon-containing resist underlayer film by dry etching with the photoresist film having the formed negative pattern as a mask; a step of transferring the pattern on the organic hard mask by dry etching with the silicon-containing resist underlayer film having the transferred pattern as a mask; and a step of further transferring the pattern on a body to be processed by dry etching with the organic hard mask having the transferred pattern as a mask.

By forming a negative pattern by using the resist underlayer film of the present invention, optimization of a combination of a CVD film and an organic underlayer film as described above can form a pattern that is formed on a photoresist on a substrate without a size conversion difference.

Moreover, a contact angle of an exposed area of the silicon-containing resist underlayer film corresponding to an exposed area of the photoresist film is preferably reduced by more than 10 degrees by exposure.

If a contact angle of the exposed area of the silicon-containing resist underlayer film is reduced by more than 10 degrees by exposure, a difference in contact angle with a resist pattern after negative development will become smaller, resulting in improved adhesiveness and no pattern fall to form a fine pattern.

The silicon-containing resist underlayer film used in the patterning process of the present invention can be produced on a body to be processed by spin coat method from the silicon-containing composition for forming a resist underlayer film of the present invention like a photoresist film. After spin coating, it is preferable that a solvent be evaporated and the silicon-containing resist underlayer film be baked to promote crosslinking reaction in order to prevent mixing with a photoresist film. Preferably, the baking temperature is in the range of 50 to 500°C and the baking duration is in the range of 10 to 300 seconds. More preferably, the temperature is less than 400°C to control thermal damage to devices, depending on the structure of a device produced.

Herein, the body to be processed can be a semiconductor device substrate, or a semiconductor device substrate coated with any of a metal film, an alloy film, a metal carbide film, a metal oxide film, a metal nitride film, a metal oxicarbide film, and a metal oxinitride film as a layer to be processed.

The semiconductor device substrate is normally a silicon substrate, but is not particularly restricted thereto, and an SI, an amorphous silicon (α-Si), a p-Si, a SiO₂, an SiN, an SiON, a W, a Tin, and an Al may be used as a material different from a layer to be processed.

The metal comprising the body to be processed may be any metal of a silicon, a gallium, a titanium, a tungsten, a hafnium, a zirconium, a chromium, a germanium, a copper, an aluminum, and an iron, or an alloy thereof. Illustrative example of the layer to be processed containing the metal includes an Si, an SiO₂, an SiN, an SiON, an SiOC, a p-Si, an α-Si, a TiN, a WSi, a BPSG, an SOG, a Cr, a CrO, a CrON, a MoSi, a W, a W-Si, an Al, a Cu, and an Al-Si, various low-dielectric films, and its etching stopper films, and the metal is normally formed with a thickness of 50 to 10,000nm, particularly 100 to 5,000nm.

In the negative patterning process of the present invention, a photoresist film is particularly restricted if it is chemically-amplified and can form a negative pattern by development by using a developer of an organic solvent.

If an exposure step in the present invention is defined as exposure by using an ArF excimer laser beam, a commonly-used resist composition for an ArF excimer laser beam can be used as a photoresist film.

In fact, many known candidate resist compositions for an ArF excimer laser beam are roughly classified into poly(meta) acrylic resins, cyclo olefin maleic anhydride (COMA), COMA-(meta) acrylic hybrid resins, ring opening methathesis polymerization resins (ROMP), and polynorbornene resins. Among these resins, resist compositions by using a poly(meta) acrylic resin have excellent resolution performance compared with other resins, due to favorable etch resistance with an alicyclic skeleton introduced into a side chain.

The negative patterning process, in which after a silicon-containing resist underlayer film is formed, a photoresist film is formed thereon by using a photoresist composition solution, preferably employs spin coat method like the silicon-containing resist underlayer film. In pre-baking of a photoresist composition after spin coating, the temperature is preferably in the range of 80 to 180°C, and the duration is in the range of 10 to 300 seconds. Thereafter, the photoresist composition is subjected to exposure and organic solvent development to obtain a negative resist pattern. Also, it is preferable that post exposure baking (PEB) be performed after exposure.

Illustrative example of the developer of the organic solvent includes a developer containing one or more components selected from a 2-octanone, a 2-nonanone, a 2-heptanone, a 3-heptanone, a 4-heptanone, a 2-hexanone, a 3-hexanone, a diisobutyl ketone, a methylcyclohexanone, an acetophenone, a methyl acetophenone, a propyl acetate, a butyl acetate, an isobutyl acetate, an amyl acetate, a butenyl acetate, an isoamyl acetate, a phenyl acetate, a propyl formate, a butyl formate, a isobutyl formate, an amyl formate, an isoamyl formate, a methyl valerate, a methyl pentenoate, a methyl crotonate, an ethyl crotonate, a methyl lactate, an ethyl lactate, a propyl lactate, a butyl lactate, an isobutyl lactate, an amyl lactate, an isoamyl lactate, a 2-hydroxyisobutyric acid methyl, a 2-hydroxyisobutyric acid ethyl, a methyl benzoate, an ethyl benzoate, a phenyl acetate, a benzyl acetate, a methyl phenyl acetate, a benzyl formate, a phenylethyl formate, a 3-phenylmethyl propionate, a benzyl propionate, a phenylethyl acetate, and a 2-phenylethyl acetate, and the total content of the one or more components in the developer is preferably more than 50% by mass to prevent pattern fall.

In the patterning process of the present invention, when the silicon-containing resist underlayer film is subjected to etching, a fluorine-containing gas such as a fluorocarbon-based gas is used as a main component. It is preferable that the silicon-containing resist underlayer film have a higher etching speed, relative to the gas, to control film thickness reduction of a photoresist film.

In the multilayer resist method, if an organic underlayer film is formed between the silicon-containing resist underlayer film and the body to be processed to define the organic underlayer film as an etching mask of the process object, the organic underlayer film preferably has an aromatic skeleton. If the organic underlayer film is a sacrifice film, it may be a silicon-containing organic underlayer film if the silicon content is less than 15% by mass.

Such example of the organic underlayer film includes a known underlayer film for three-layer resist method, a known underlayer film for two-layer resist method by using a silicon resist composition, a 4,4'-(9-fluorenylidene) bisphenolic novolac resin (molecular weight: 11,000) described in Japanese Unexamined Patent Publication No. 2005-128509, and other kinds of resins like a novolac resin. Specifically, known resist underlayer film material of two-layer resist method and three-layer resist method can be used. Also, if heat resistance needs to be improved over a normal novolac resin, a polycyclic skeleton such as a 6,6'-(9-fluorenylidene)-di(2-naphthol) novolac resin can be introduced, and a polyimide resin can be selected (e.g. Japanese Unexamined Patent Publication No. 2004-153125).

The above organic underlayer film can be formed on a body to be processed by spin coat method like a photoresist composition, by using a composition solution. It is preferable that after an organic underlayer film be formed by spin coat method, the organic underlayer film be baked to evaporate the organic solvent. Preferably, the baking temperature is in the range of 80 to 300°C, and the baking duration is in the range of 10 to 300 seconds.

The thickness of the organic underlayer film is not particularly restricted, but it is preferably more than 5nm, particularly preferable more than 20nm and less than 50,000nm, depending on etching processing conditions. The thickness of the silicon-containing resist underlayer film according to the present invention is preferably more than 1nm and less than 500nm, more preferably less than 300nm, and much more preferably less than 200nm. The thickness of the photoresist film is preferably more than 1nm and less than 200nm.

### Patterning process of the present invention by three-layer resist method

The negative patterning process of the present invention by three-layer resist method mentioned above is as follows (Fig. 1). In this method, an organic underlayer film 2 is formed on a body to be processed 1 by spin coat method (Fig. 1(I-A)). The organic underlayer film 2 acts as a mask for etching the body to be processed 1, thus the etching resistance is preferably high, and it is preferable that it be crosslinked by heating or acid reaction after spin coating because it is not supposed to mix with the upper-layer silicon-containing resist underlayer film.

By using a silicon-containing composition for forming a resist underlayer film of the present invention, a silicon-containing resist underlayer film 3 is coated thereon by spin coat method (Fig. 1(I-B)), and a photoresist film 4 is coated thereon by spin coat method (Fig. 1(I-C)). The silicon-containing resist underlayer film 3 can be formed by using a composition whose contact angle of the silicon-containing resist underlayer film 3 corresponding to the exposed area to purified water after exposure is more than 40 degrees and less than 70 degrees, when the photoresist film 4 is exposed.

The photoresist film 4 is patterned by using a mask 5 according to a conventional method by pattern exposure by using a light source P appropriate for the photoresist film 4 such as a KrF excimer laser beam, an ArF excimer laser beam, an F₂ laser beam, or an EUV beam, or preferably any of an optical lithography whose wavelength is more than 10nm and less than 300nm, a direct writing by electron beam, and a nano-imprinting, or in combination therewith (Fig. 1(I-D)). After heat treatment by conditions in accordance with each photoresist film (Fig. 1(I-E)), negative development by an organic developer, and subsequent rinsing as required can obtain a negative resist pattern 4a (Fig. 1(I-F)).

Next, with the negative resist pattern 4a as an etching mask, the photoresist film is subjected to dry etching by using a fluorine-based gas plasma on condition that an etching speed of the silicon-containing resist underlayer film 3 is advantageously high. As a result, a negative silicon-containing resist underlayer film pattern 3a can be obtained, with little effect of change in pattern from side etching of a resist film (Fig. 1(I-G)).

Next, a substrate having a negative silicon-containing resist underlayer film pattern 3a in which the negative resist pattern 4a obtained above is transferred is subjected to dry etching such as a reactive dry etching by a gas plasma containing oxygen and a reactive dry etching by a gas plasma containing hydrogen and nitrogen, on condition that an etching speed of the organic underlayer film 2 is advantageously high to perform etching processing of the organic underlayer film 2. The etching process obtains the negative organic underlayer film pattern 2a, but normally loses an uppermost photoresist film (Fig. 1(I-H)). Moreover, with the negative organic underlayer film pattern 2a obtained herein as an etching mask, the body to be processed 1 is subjected to dry etching such as fluorine-based dry etching and chlorine-based dry etching to precisely process the body to be processed 1 and transfer the negative pattern 1a on the body to be processed 1 (Fig. 1(I-I)).

In the above method by three-layer resist method, an organic hard mask formed by CVD method can be applied, instead of the organic underlayer film 2. In this case, the body to be processed can be processed like in the above manner.

### Positive patterning process

### Positive patterning process 1

The present invention provides a patterning process comprising a step of forming an organic underlayer film on a body to be processed by using an application-type composition for organic underlayer film; a step of forming a silicon-containing resist underlayer film on the organic underlayer film by using the silicon-containing composition for forming a resist underlayer film; a step of forming a photoresist film on the silicon-containing resist underlayer film by using a chemically-amplified resist composition; a step of, after a heat-treatment, forming a positive pattern by exposure of the photoresist film by a high energy radiation and by dissolution of an exposed area of the photoresist film by using an alkaline developer, transferring the pattern on the silicon-containing resist underlayer film by dry etching with the photoresist film having the formed positive pattern as a mask; a step of transferring the pattern on the organic underlayer film by dry etching with the silicon-containing resist underlayer film having the transferred pattern as a mask; and a step of further transferring the pattern on the body to be processed by dry etching with the organic underlayer film having the transferred pattern as a mask.

### Positive patterning process 2

The present invention provides a patterning process comprising a step of forming an organic hard mask mainly comprising carbon on a body to be processed by CVD method; a step of forming a silicon-containing resist underlayer film on the organic hard mask by using the above silicon-containing composition for forming a resist underlayer film; a step of forming a photoresist film on the silicon-containing resist underlayer film by using a chemically-amplified resist composition; a step of, after a heat-treatment, forming a positive pattern by exposure of the photoresist film by a high energy radiation and by dissolution of an exposed area of the photoresist film by using an alkaline developer; a step of transferring the pattern on the silicon-containing resist underlayer film by dry etching with the photoresist film having the formed positive pattern as a mask; a step of transferring the pattern on the organic hard mask by dry etching with the silicon-containing resist underlayer film having the transferred pattern as a mask; and a step of further transferring the pattern on the body to be processed by dry etching with the organic hard mask having the transferred pattern as a mask.

By patterning by positive development by using the resist underlayer film of the present invention, optimization of a combination of a CVD film and an organic underlayer film as described above can form a pattern that is formed on a photoresist on a substrate without a size conversion difference.

In the positive patterning process of the present invention, a photoresist film is particularly restricted if it is chemically-amplified and can form a positive pattern by development by using an alkaline developer. A coating method, a process object, an organic underlayer film, and an organic hard mask can be the ones described in the negative patterning process.

In the positive patterning process, after forming a photoresist film and a heat-treatment, the photoresist film is subjected to exposure and alkaline development by using an alkaline developer to obtain a positive resist pattern. Preferably, post-exposure baking (PEB) is performed after exposure.

Illustrative example of the alkaline developer includes a tetramethyl ammonium hydroxide (TMAH).

### Patterning process of the present invention by three-layer resist method

The positive patterning process of the present invention by three-layer resist method is as follows (Fig. 1). In this method, an organic underlayer film 2 is formed on a body to be processed 1 by spin coat method (Fig. 1(II-A)). The organic underlayer film 2 acts as a mask for etching the body to be processed 1, thus the etch resistance is preferably high, and it is preferable that it be crosslinked by heating or acid reaction after spin coating because it is not supposed to mix with the upper-layer silicon-containing resist underlayer film.

By using a silicon-containing composition for forming a resist underlayer film of the present invention, a silicon-containing resist underlayer film 3 is coated thereon by spin coat method (Fig. 1(II-B)), and a photoresist film 4 is coated thereon by spin coat method (Fig. 1(II-C)). The silicon-containing resist underlayer film 3 can be formed by using a composition whose contact angle of the silicon-containing resist underlayer film 3 corresponding to the exposed area to purified water after exposure is more than 40 degrees and less than 70 degrees, when the photoresist film 4 is exposed.

The photoresist film 4 is patterned by using a mask 5 according to a conventional method by pattern exposure by using a light source P appropriate for the photoresist film 4 such as a KrF excimer laser beam, an ArF excimer laser beam, an F₂ laser beam, or an EUV beam, or preferably any of an optical lithography whose wavelength is more than 10nm and less than 300nm, a direct writing by electron beam, and a nano-imprinting, or in combination therewith (Fig. 1(II-D)). After heat treatment by conditions in accordance with each photoresist film (Fig. 1(II-E)), positive development by an alkaline developer, and subsequent rinsing as required can obtain a positive resist pattern 4b (Fig. 1(II-F)).

Next, with the positive resist pattern 4b as an etching mask, the photoresist film is subjected to dry etching by using a fluorine-based gas plasma on condition that an etching speed of the silicon-containing resist underlayer film 3 is advantageously high. As a result, a positive silicon-containing resist underlayer film pattern 3b can be obtained, with minimal effect of change in pattern from side etching of a resist film (Fig. 1(II-G)).

Next, a substrate having a positive silicon-containing resist underlayer film pattern 3b in which the positive resist pattern 4b obtained above is transferred is subjected to dry etching such as a reactive dry etching by a gas plasma containing oxygen and a reactive dry etching by a gas plasma containing hydrogen and nitrogen, on condition that an etching speed of the organic underlayer film 2 is advantageously high to perform etching processing of the organic underlayer film 2. The etching process obtains the positive organic underlayer film pattern 2b, but normally loses an uppermost photoresist film (Fig. 1(II-H)). Moreover, with the positive organic underlayer film pattern 2b obtained herein as an etching mask, the body to be processed 1 is subjected to dry etching such as fluorine-based dry etching and chlorine-based dry etching to precisely process the body to be processed 1 and transfer the positive pattern 1b on the body to be processed 1 (Fig. 1(II-I)).

In the above process by three-layer resist method, an organic hard mask formed by CVD method can be applied, instead of the organic underlayer film 2. In this case, the body to be processed can be processed like in the above manner.

### EXAMPLES

The present invention will be specifically described with reference to Synthesis Examples, Examples and Comparative Examples, but it is not restricted thereto. "%" in the following Examples represents "% by mass," and the molecular weight is measured by GPC.

The silicon compound of the present invention is synthesized by the following process.

### [Synthesis Example 1-1] Synthesis of silicon compound 1

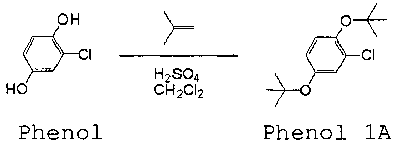

A phenol 1 (149.9g) and a dichloromethane (500g) were mixed and a concentrated sulfuric acid (2.3g) was added thereto. Subsequently, a 2-methyl propene gas was bubbled at room temperature. After 8-hour agitation, bubbling of the 2-methyl propene gas was stopped, and a 5% sodium hydroxide aqueous solution was added thereto to stop reaction. An organic phase was diluted with a hexane, and it was washed with a 5% sodium hydroxide aqueous solution to distill off a solvent. Afterward, the mixture was purified by distillation (0.1kPa, 98°C) to obtain a phenol 1A (169.2g) (yield: 64%).

### Phenol 1A

¹H-NMR (600MHz in DMSO-d6): δ=1.25 (9H, s), 1.31 (9H, s), 6.86 (1H, dd, J=8.7, 2.8Hz), 7.02 (1H, d, J=2.8Hz), 7.08 (1H, d, J=8.7Hz) ppm.
IR (D-ATR): ν=2978, 2934, 1595, 1558, 1484, 1391, 1366, 1260, 1206, 1159, 1047, 940, 925, 898, 883, 850, 799, 683, 648, 611, 581cm⁻¹.

### Synthesis Example 1-2

### Synthesis of silicon compound 1

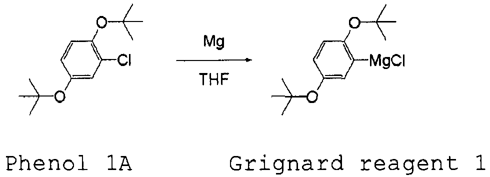

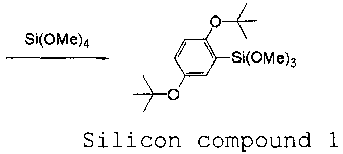

A magnesium (4.2g) and a THF were added to a 300ml four-necked glass flask having a thermometer, a glass dimroth radiator and an addition funnel, and in nitrogen atmosphere, and the mixture was agitating with a magnetic stirrer, and a solution in which a phenol 1A (42.3g) is dissolved in THF (50ml) was dropped with a pot temperature of 60 to 100°C. After completion of dropping, the reaction mixture was agitated at 100°C for 20 hours to prepare a Grignard reagent 1. Next, a tetramethoxysilane (60g) and a THF (100ml) were added to a 500ml four-necked glass flask having a thermometer, a glass dimroth radiator, a mechanical stirrer and an addition funnel, and in nitrogen atmosphere, the Grignard reagent 1 whose temperature returned to normal temperature was dropped with a temperature in the flask maintained at 45°C, and after completion of dropping, the mixture was agitated and heated to reflux for 1 hour. Afterward, the temperature returned to normal temperature and a hexane (200g) was added thereto to remove a deposited salt by filtration and distill off the salt deposited at a low boiling point. The residual material was refined by distillation to obtain a silicon compound 1 (35.7g) (yield: 63%).

### Silicon compound 1 (Boiling point: 123°C at 0.1kPa)

¹H-NMR (600MHz in DMSO-d6): δ=1.22(9H, s), 1.38(9H, s), 3.50(9H, s), 6.95(1H, dd, J=9.0, 2.9Hz), 7.01(1H, d, J=2.9Hz), 7.02(1H, d, J=9.0Hz) ppm.
IR (D-ATR): ν=2976, 2942, 2840, 1566, 1471, 1389, 1365, 1262, 1214, 1163, 1088, 929, 900, 852, 814, 748, 724, 662cm⁻¹.

### Synthesis Example 2-1

### Synthesis of silicon compound 2

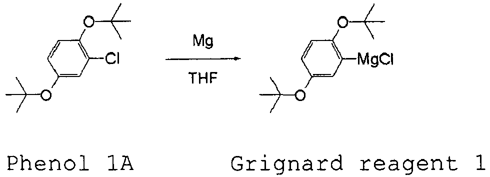

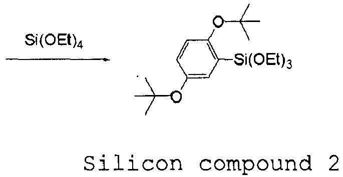

A magnesium (4.2g) and a THF were added to a 300ml four-necked glass flask having a thermometer, a glass dimroth radiator and an addition funnel, and in nitrogen atmosphere, and the mixture was agitating with a magnetic stirrer, and a solution in which a phenol 1A (42.3g) is dissolved in THF (50ml) was dropped with a pot temperature of 60 to 100°C. After completion of dropping, the reaction mixture was agitated at 100°C for 20 hours to prepare a Grignard reagent 1. Next, a tetraethoxysilane (80g) and a THF (100ml) were added to a 500ml four-necked glass flask having a thermometer, a glass dimroth radiator, a mechanical stirrer and an addition funnel, and in nitrogen atmosphere, the Grignard reagent 1 whose temperature returned to normal temperature was dropped with a temperature in the flask maintained at 45°C, and after completion of dropping, the mixture was agitated and heated to reflux for 1 hour. Afterward, the temperature returned to normal temperature and a hexane (200g) was added thereto to remove a deposited salt by filtration and distill off the salt deposited at a low boiling point. The residual material was refined by distillation to obtain a silicon compound 2 (39.1g) (yield: 61%).

### Synthesis Example 3-1

### Synthesis of silicon compound 3

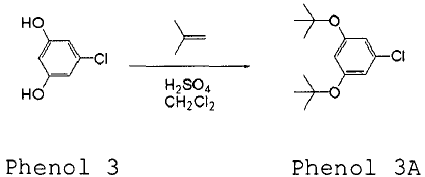

A phenol 3 (149.9g) and a dichloromethane (500g) were mixed and a concentrated sulfuric acid (2.3g) was added thereto. Subsequently, a 2-methyl propene gas was bubbled at room temperature. After 8-hour agitation, bubbling of the 2-methyl propene gas was stopped, and a 5% sodium hydroxide aqueous solution was added thereto to stop reaction. An organic phase was diluted with a hexane, and it was washed with a 5% sodium hydroxide aqueous solution to distill off a solvent. Afterward, the mixture was purified by distillation (0.1kPa, 98°C) to obtain a phenol 3A (159.0g) (yield: 60%).

### Phenol 3A

¹H-NMR(600MHz in CDCl₃): δ=1.273 (18H, s), 6.471 (1H, dd, J=1.8Hz), 6.671(2H, d, J=1.8Hz) ppm.
¹³C-NMR(150MHz, in CDCl₃): δ=28.81, 79.40, 118.34, 119.51, 133.36, 156.34ppm.
IR (D-ATR) 2973, 2932, 2903, 2871, 1589, 1574, 1471, 1458, 1428, 1390, 1363, 1282, 1261, 1242, 175, 1129, 1084, 1037, 1010, 929, 907, 893, 872, 860, 832, 736, 701, 607cm⁻¹.

### Synthesis Example 3-2

### Synthesis of silicon compound 3

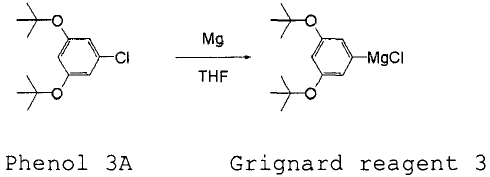

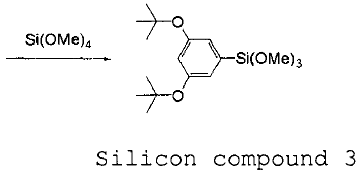

A magnesium (4.2g) and a THF were added to a 300ml four-necked glass flask having a thermometer, a glass dimroth radiator and an addition funnel, and in nitrogen atmosphere, and the mixture was agitating with a magnetic stirrer, and a solution in which a phenol 3A (42.0g) is dissolved in THF (50ml) was dropped with a pot temperature of 60 to 100°C. After completion of dropping, the reaction mixture was agitated at 100°C for 20 hours to prepare a Grignard reagent 3. Next, a tetraethoxysilane (80g) and a THF (100ml) were added to a 500ml four-necked glass flask having a thermometer, a glass dimroth radiator, a mechanical stirrer and an addition funnel, and in nitrogen atmosphere, the Grignard reagent 3 whose temperature returned to normal temperature was dropped with a temperature in the flask maintained at 45°C, and after completion of dropping, the mixture was agitated and heated to reflux for 1 hour. Afterward, the temperature returned to normal temperature and a hexane (200g) was added thereto to remove a deposited salt by filtration and distill off the salt deposited at a low boiling point. The residual material was refined by distillation to obtain a silicon compound 3 (36.0g) (yield: 64%).

### Silicon compound 3 (Boiling point: 123°C at 0.1kPa)

¹H-NMR (600MHz in CDCl₃): δ=1.015(18H, s), 3.275 (9H, s), 6.421 (1H, dd, J=1.8Hz), 6.682 (2H, d, 1.8Hz) ppm.
¹³C-NMR (150MHz, in CDCl₃): δ=28.83, 50.80, 78.64, 122.71, 125.43, 129, 74, 155.56ppm.
IR (D-ATR) 2977, 2942, 2840, 1572, 1475, 1402, 1391, 1366, 1284, 1259, 1237, 1182, 1133, 1086, 1035, 1007, 939, 899, 837, 813, 750, 717, 691cm⁻¹.

The following silicon compounds 4 to 7 were synthesized by using the same step.

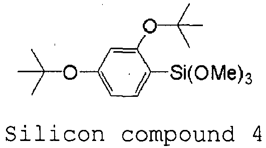

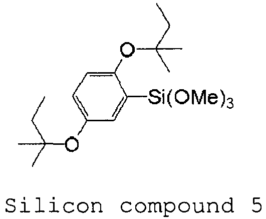

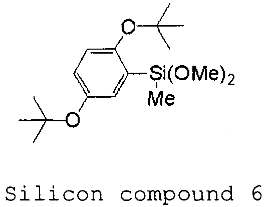

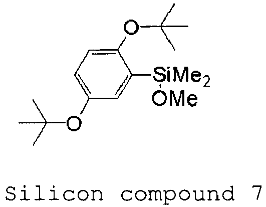

### Production of silicon-containing compound

### Example 1-1

A mixture of [monomer 1] (30.6g), [monomer 2] (38.1g) and [monomer 20] (9.6g) was added to a mixture of a methanol (200g), a methanesulfonic acid (0.1g) and a deionized water (60g), and the temperature was maintained at 40°C for 12 hours to be subjected to hydrolytic condensation. After completion of the reaction, a propylene glycolethylether (PGEE) (200g) was added thereto to distill off a by-product alcohol under reduced pressure. An ethyl acetate (1000ml) and a PGEE (300g) were added thereto to separate a water layer. An ion-exchanged water (100ml) was added to a residual organic layer, and the mixture was agitated and allowed to stand to separate a liquid. This step was repeated three times. The residual organic layer was concentrated under reduced pressure to obtain a PGEE solution of a silicon-containing compound 1-1 (350g) (Compound concentration: 10%). The molecular weight (Mw) measured in terms of polystyrene was 2,300.

By using reactants shown in Table 1 on the same condition as [Preparation Example 1-1], desired products were obtained in [Preparation Example 1-2] to [Preparation Example 1-18].

### Preparation Example 1-19

A mixture of [monomer 0] (5.0g), [monomer 1] (3.4g) and [monomer 2] (68.5g) was added to a mixture of a methanol (120g), a 70% nitric acid (0.1g) and a deionized water (60g), and the temperature was maintained at 40°C for 12 hours to be subjected to hydrolytic condensation. After completion of the reaction, a PGEE (300g) was added thereto and a by-product alcohol and excessive water were distilled off under reduced pressure to obtain a PGEE solution of a polysiloxane compound 1-19 (310g) (Polymer concentration: 10%). The molecular weight (Mw) measured in terms of polystyrene was 3,400.

By using reactants shown in Table 1 on the same condition as [Preparation Example 1-19], desired products were obtained in [Preparation Example 1-20] to [Preparation Example 1-26].

**[Table 1]**

| Preparation Example | Reaction material | Mw |
|---|---|---|
| 1-1 | [Monomer 1]: 30.6g, [Monomer 2]: 38.1g, [Monomer 20]: 9.6g | 2300 |
| 1-2 | [Monomer 1]: 30.6g, [Monomer 2]: 38.1g, [Monomer 21]: 8.6g | 2100 |
| 1-3 | [Monomer 1]: 30.6g, [Monomer 2]: 38.1g, [Monomer 22]: 8.6g | 2100 |
| 1-4 | [Monomer 1]: 30.6g, [Monomer 2]: 38.1g, [Monomer 24]: 8.2g | 2000 |
| 1-5 | [Monomer 1]: 30.6g, [Monomer 2]: 38.1g, [Monomer 25]: 7.8g | 2200 |
| 1-6 | [Monomer 1]: 20.6g, [Monomer 22]: 119.9g | 1500 |
| 1-7 | [Monomer 1]: 20.6g, [Monomer 23]: 119.9g | 1300 |
| 1-8 | [Monomer 1]: 34.1g, [Monomer 24]: 81.6g | 1700 |
| 1-9 | [Monomer 1]: 47.7g, [Monomer 25]: 46.6g | 1500 |
| 1-10 | [Monomer 1]: 20.4g, [Monomer 2]: 18.8, [Monomer 20]: 85.6g | 1900 |
| 1-11 | [Monomer 1]: 30.6g, [Monomer 11]: 8.5g, [Monomer 20]: 85.6g | 2500 |
| 1-12 | [Monomer 1]: 30.6g, [Monomer 12]: 9.1g, [Monomer 20]: 85.6g | 2300 |
| 1-13 | [Monomer 1]: 20.4g, [Monomer 13]: 28.4g, [Monomer 20]: 85.6g | 2300 |
| 1-14 | [Monomer 1]: 30.6g, [Monomer 14]: 8.1g, [Monomer 20]: 85.6g | 2300 |
| 1-15 | [Monomer 1]: 30.6g, [Monomer 2]: 38.1g, [Monomer 5]: 5.7g | 2100 |
| 1-16 | [Monomer 1]: 20.4g, [Monomer 5]: 79.9g | 1300 |
| 1-17 | [Monomer 1]: 30.6g, [Monomer 2]: 38.1g, [Monomer 26]: 6.8g | 2100 |
| 1-18 | [Monomer 1]: 20.4g, [Monomer 26]: 94.6g | 1600 |
| 1-19 | [Monomer 0]: 5.0g, [Monomer 1]: 3.4g, [Monomer 2]: 68.5g | 3400 |
| 1-20 | [Monomer 4]: 5.3g, [Monomer 1]: 3.4g, [Monomer 2]: 68.5g | 3400 |
| 1-21 | [Monomer 5]: 5.7g, [Monomer 1]: 3.4g, [Monomer 2]: 68.5g | 3400 |
| 1-22 | [Monomer 0]: 5.0g, [Monomer 1]: 6.8g, [Monomer 2]: 60.9g, [Monomer 10]: 4.7g | 3500 |
| 1-23 | [Monomer 0]: 5.0g, [Monomer 1]: 6.8g, [Monomer 2]: 60.9g, [Monomer 11]: 8.5g | 3600 |
| 1-24 | [Monomer 0]: 5.0g, [Monomer 1]: 6.8g, [Monomer 2]: 60.9g, [Monomer 12]: 9.1g | 4100 |
| 1-25 | [Monomer 0]: 5.0g, [Monomer 1]: 6.8g, [Monomer 2]: 60.9g, [Monomer 13]: 7.1g | 3800 |
| 1-26 | [Monomer 0]: 5.0g, [Monomer 1]: 6.8g, [Monomer 2]: 60.9g, [Monomer 14]: 8.1g | 3900 |

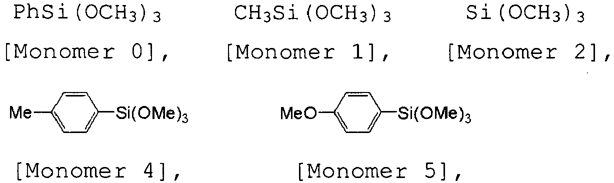

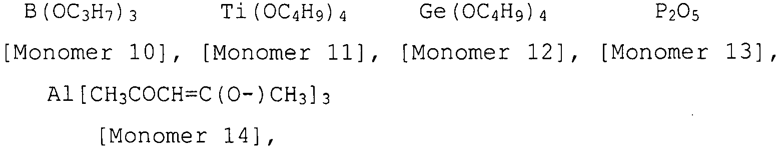

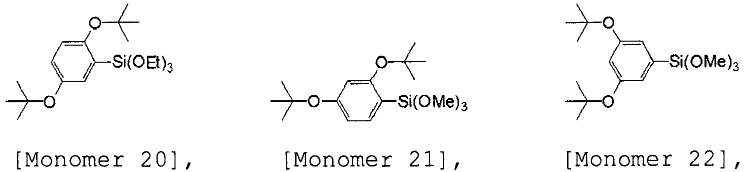

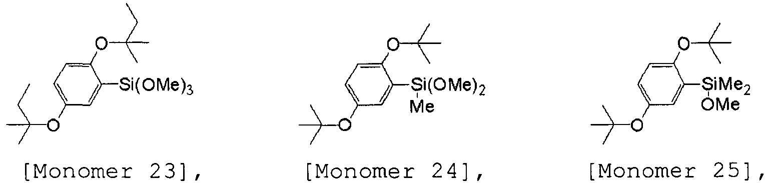

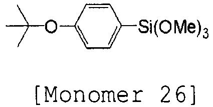

### Examples and Comparative Examples

The silicon-containing compounds (1-1) to (1-26) obtained in the above Preparation Examples, an acid, a thermal crosslinking accelerator, a solvent and an additive were mixed with the ratios as shown in Tables 2 and 3. By filtering the mixture with a 0.1µm fluorine resin filter, each solution of a silicon-containing composition for forming a resist underlayer film was prepared to be defined as Sol. 1 to 38.

**[Table 2]**

| No. | Polysiloxane (mass) | Thermal crosslinking accelerator (mass) | Photoacid generator (mass) | Acid (mass) | Solvent (mass) | Water (mass) |
|---|---|---|---|---|---|---|
| Sol. 1 | 1-1 (4.0) | TPSOH (0.04) | None | Maleic acid (0.04) | PGEE (150) | Water (15) |
| Sol. 2 | 1-1 (4.0) | TPSHCO₃ (0.04) | None | Oxalic acid (0.04) | PGEE (150) | Water (15) |
| Sol. 3 | 1-1 (4.0) | TPSOx (0.04) | None | Maleic acid (0.04) | PGEE (150) | Water (15) |
| Sol. 4 | 1-1 (4.0) | TPSTFA (0.04) | None | Maleic acid (0.04) | PGEE (150) | Water (15) |
| Sol. 5 | 1-1 (4.0) | TPSOCOPh (0.04) | None | Oxalic acid (0.04) | PGEE (150) | Water (15) |
| Sol. 6 | 1-1 (4.0) | TPSH₂PO₄ (0.04) | None | Oxalic acid (0.04) | PGEE (150) | Water (15) |
| Sol. 7 | 1-1 (4.0) | QMAMA (0.04) | None | Maleic acid (0.04) | PGEE (150) | Water (15) |
| Sol. 8 | 1-1 (4.0) | ABANO₃ (0.04) | None | Maleic acid (0.04) | PGEE (150) | Water (15) |
| Sol. 9 | 1-1 (4.0) | QMATFA (0.04) | TPSNf (0.04) | Maleic acid (0.04) | PGEE (150) | Water (15) |
| Sol. 10 | 1-1 (4.0) | Ph₂lCl (0.04) | None | Maleic acid (0.04) | PGEE (150) | Water (15) |
| Sol. 11 | 1-1 (4.0) | TPSMA (0.04) | None | Maleic acid (0.04) | PGEE (150) | Water (15) |
| Sol. 12 | 1-2 (4.0) | TPSMA (0.04) | None | Maleic acid (0.04) | PGEE (150) | Water (15) |
| Sol. 13 | 1-3 (4.0) | TPSMA (0.04) | None | Maleic acid (0.04) | PGEE (150) | Water (15) |
| Sol. 14 | 1-4 (4.0) | TPSMA (0.04) | None | Maleic acid (0.04) | PGEE (150) | Water (15) |
| Sol. 15 | 1-5 (4.0) | TPSMA (0.04) | None | Maleic acid (0.04) | PGEE (150) | Water (15) |
| Sol. 16 | 1-6 (0.1) | TPSMA (0.04) | None | Oxalic acid (0.04) | PGEE (150) | Water (15) |
| | 1-19 (3.9) | | | | | |
| Sol. 17 | 1-7 (0.1) | TPSMA (0.04) | None | Maleic acid (0.04) | PGEE (150) | Water (15) |
| | 1-19 (3.9) | | | | | |
| Sol. 18 | 1-8 (0.1) | TPSMA (0.04) | None | Maleic acid (0.04) | PGEE (150) | Water (15) |
| | 1-19 (3.9) | | | | | |
| Sol. 19 | 1-9 (0.1) | TPSMA (0.04) | None | Maleic acid (0.04) | PGEE (150) | Water (15) |
| | 1-20 (3.9) | | | | | |
| Sol. 20 | 1-10 (0.1) | TPSMA (0.04) | TPSNf (0.04) | Maleic acid (0.04) | PGEE (150) | Water (15) |
| | 1-20 (3.9) | | | | | |
| Sol. 21 | 1-11 (0.1) | TPSMA (0.04) | None | Maleic acid (0.04) | PGEE (150) | Water (15) |
| | 1-20 (3.9) | | | | | |
| Sol. 22 | 1-12 (0.1) | TPSMA (0.04) | None | Maleic acid (0.04) | PGEE (150) | Water (15) |
| | 1-21 (3.9) | | | | | |
| Sol. 23 | 1-13 (0.1) | TPSMA (0.04) | None | Maleic acid (0.04) | PGEE (150) | Water (15) |
| | 1-21 (3.9) | | | | | |
| Sol. 24 | 1-14 (0.1) | TPSMA (0.04) | None | Maleic acid (0.04) | PGEE (150) | Water (15) |
| | 1-21 (3.9) | | | | | |
| Sol. 25 | 1-7 (0.1) | TPSMA (0.04) | None | Maleic acid (0.04) | PGEE (150) | Water (15) |
| | 1-22 (3.9) | | | | | |

**[Table 3]**

| No. | Polysiloxane (mass) | Thermal crosslinking accelerator (mass) | Photoacid generator (mass) | Acid (mass) | Solvent (mass) | Water (mass) |
|---|---|---|---|---|---|---|
| Sol. 26 | 1-7 (0.1) | TPSMA (0.04) | None | Maleic acid (0.04) | PGEE (150) | Water (15) |
| | 1-23 (3.9) | | | | | |
| Sol. 27 | 1-7 (0.1) | TPSMA (0.04) | None | Maleic acid (0.04) | PGEE (150) | Water (15) |
| | 1-24 (3.9) | | | | | |
| Sol. 28 | 1-8 (0.1) | TPSMA (0.04) | None | Maleic acid (0.04) | PGEE (150) | Water (15) |
| | 1-25 (3.9) | | | | | |
| Sol. 29 | 1-9 (0.1) | TPSMA (0.04) | None | Maleic acid (0.04) | PGEE (150) | Water (15) |
| | 1-26 (3.9) | | | | | |
| Sol. 30 | 1-10 (0.1) | TPSMA (0.04) | TPSNf (0.04) | Maleic acid (0.04) | PGEE (150) | Water (15) |
| | 1-22 (3.9) | | | | | |
| Sol. 31 | 1-11 (0.1) | TPSMA (0.04) | None | Maleic acid (0.04) | PGEE (150) | Water (15) |
| | 1-22 (3.9) | | | | | |
| Sol. 32 | 1-12 (0.1) | TPSMA (0.04) | None | Maleic acid (0.04) | PGEE (150) | Water (15) |
| | 1-22 (3.9) | | | | | |
| Sol. 33 | 1-13 (0.1) | TPSMA (0.04) | None | Maleic acid (0.04) | PGEE (135) | Water (15) |
| | 1-22 (3.9) | | | | GBL (15) | |
| Sol. 34 | 1-14 (0.1) | TPSMA (0.04) | None | Maleic acid (0.04) | PGEE (150) | Water (15) |
| | 1-22 (3.9) | | | | | |
| Sol. 35 | 1-15 (4.0) | TPSMA (0.04) | None | Maleic acid (0.04) | PGEE (150) | Water (15) |
| Sol. 36 | 1-17 (4.0) | TPSMA (0.04) | None | Maleic acid (0.04) | PGEE (135) | Water (15) |
| | | | | | GBL (15) | |
| Sol. 37 | 1-16 (0.1) | TPSMA (0.04) | None | Maleic acid (0.04) | PGEE (150) | Water (15) |
| | 1-19 (3.9) | | | | | |
| Sol. 38 | 1-18 (0.1) | TPSMA (0.04) | None | Maleic acid (0.04) | PGEE (150) | Water (15) |
| | 1-19 (3.9) | | | | | |

TPSOH: triphenylsulfonium hydroxide
TPSHCO₃: mono (triphenylsulfonium) carbonate
TPSOₓ: mono (triphenylsulfonium) oxalate
TPSTFA: triphenylsulfonium trifluoroacetate
TPSOCOPh: triphenylsulfonium benzoate
TPSH₂PO₄: mono (triphenylsulfonium) phosphate
TPSMA: mono (triphenylsulfonium) malate
TPSNf: triphenylsulfonium nonafluorobutanesulfonate
QMAMA: mono (tetramethylammonium) malate
QMATFA: tetramethylammonium trifluoroacetate
QBANO₃: tetrabutylammonium nitrate
PH₂ICl: diphenyliodonium chloride
PGEE: propylene glycolethylether
GBL: gamma butyrolactone

### Measurement of contact angle

Contact angle sample of non-exposed area of underlayer film having applied and stripped resist for positive development on underlayer film
The silicon-containing compositions for forming a resist underlayer film (Sol. 1 to 38) were applied on a silicon wafer and heated at 240°C for 60 seconds to produce 35nm silicon-containing films (Film 1 to 38). An ArF resist solution (PR-1) described in Table 8 was applied thereon and baked at 100°C for 60 seconds to form a 100nm photoresist layer. Subsequently, all the resist films were rinse-removed with a propylene glycolmonomethyl ether (PGME) to obtain a film equivalent to a non-exposed area of the silicon-containing film. The contact angle (CA1) to purified water was measured (Table 4).

### Contact angle sample of exposed area of underlayer film stripped after applying and exposing a resist for negative development on an underlayer film

The silicon-containing compositions for forming a resist underlayer film (SOl. 1 to 38) were applied to a silicon wafer and heated at 240°C for 60 seconds to produce 35nm silicon-containing films (Films 1 to 38). An ArF resist solution for negative development (PR-2) described in Table 11 was applied thereon and baked at 100°C for 60 seconds to form a 100nm photoresist layer. An immersion top coat (TC-1) described in Table 9 was further applied on a photoresist film and baked at 90°C for 60 seconds to form a 50nm top coat. Subsequently, the immersion top coat was subjected to overall exposure with an ArF immersion exposure device (Product from Nikon Corporation; NSR-S610C) and baking at 100°C for 60 seconds (PEB). After the product was rotated at 30rpm to discharge butyl acetate as a developer from a developing nozzle for 3 seconds, rotation was stopped and paddle development was performed for 27 seconds. The product was spin-dried with diisoamyl ether after rinsing and baked at 100°C for 20 seconds to evaporate a rinsing solvent. All residual resist films were rinse-removed with PGME to obtain a film of an exposed area of a silicon-containing film. A contact angle (CA2) to purified water was measured (Table 5).

### Contact angle sample of non-exposed area of resist for positive development

An ArF resist solution (PR-1) described in Table 8 was applied on a silicon wafer and baked at 100°C for 60 seconds to form a 100nm photoresist film. A contact angle to purified water was measured (Table 6).

### Contact angle sample of exposed area of resist for negative development

An ArF resist solution (PR-2) for negative development described in Table 11 was applied on a silicon wafer and baked at 100°C for 60 seconds to prepare a 100nm photoresist film. A contact angle to purified water was measured. Subsequently, the same resist film was subjected to overall exposure with an ArF immersion exposure device (Product from Nikon Corporation; NSR-S610C) and baking at 100°C for 60 seconds (PEB). After the product was rinsed with diisoamyl ether for spin drying, it was baked at 100°C for 20 seconds to evaporate a rinsing solvent and prepare an ArF resist film that is equivalent to a pattern portion during negative development in which an acid leaving group is removed. A contact angle to purified water was measured (Table 7).

**[Table 4]**

| No. | Contact angle | No. | Contact angle | No. | Contact angle | No. | Contact angle |
|---|---|---|---|---|---|---|---|
| Film 1 | 69 deg. | Film 11 | 70 deg. | Film 21 | 70 deg. | Film 31 | 73 deg. |
| Film 2 | 72 deg. | Film 12 | 69 deg. | Film 22 | 72 deg. | Film 32 | 74 deg. |
| Film 3 | 71 deg. | Film 13 | 68 deg. | Film 23 | 75 deg. | Film 33 | 71 deg. |
| Film 4 | 66 deg. | Film 14 | 68 deg. | Film 24 | 69 deg. | Film 34 | 77 deg. |
| Film 5 | 66 deg. | Film 15 | 68 deg. | Film 25 | 71 deg. | Film 35 | 62 deg. |
| Film 6 | 72 deg. | Film 16 | 78 deg. | Film 26 | 73 deg. | Film 36 | 64 deg. |
| Film 7 | 69 deg. | Film 17 | 71 deg. | Film 27 | 72 deg. | Film 37 | 65 deg. |
| Film 8 | 74 deg. | Film 18 | 69 deg. | Film 28 | 75 deg. | Film 38 | 66 deg. |
| Film 9 | 74 deg. | Film 19 | 74 deg. | Film 29 | 74 deg. | | |
| Film 10 | 75 deg. | Film 20 | 79 deg. | Film 30 | 76 deg. | | |

**[Table 5]**

| No. | Contact angle | No. | Contact angle | No. | Contact angle | No. | Contact angle |
|---|---|---|---|---|---|---|---|
| Film 1 | 26 deg. | Film 11 | 33 deg. | Film 21 | 34 deg. | Film 31 | 24 deg. |
| Film 2 | 38 deg. | Film 12 | 23 deg. | Film 22 | 30 deg. | Film 32 | 29 deg. |
| Film 3 | 33 deg. | Film 13 | 27 deg. | Film 23 | 39 deg. | Film 33 | 31 deg. |
| Film 4 | 23 deg. | Film 14 | 29 deg. | Film 24 | 24 deg. | Film 34 | 33 deg. |
| Film 5 | 25 deg. | Film 15 | 27 deg. | Film 25 | 36 deg. | Film 35 | 58 deg. |
| Film 6 | 33 deg. | Film 16 | 33 deg. | Film 26 | 33 deg. | Film 36 | 42 deg. |
| Film 7 | 39 deg. | Film 17 | 24 deg. | Film 27 | 25 deg. | Film 37 | 60 deg. |
| Film 8 | 29 deg. | Film 18 | 23 deg. | Film 28 | 32 deg. | Film 38 | 40 deg. |
| Film 9 | 30 deg. | Film 19 | 32 deg. | Film 29 | 39 deg. | | |
| Film 10 | 21 deg. | Film 20 | 29 deg. | Film 30 | 33 deg. | | |

**[Table 6]**

| No. | Contact angle |
|---|---|
| Non-exposed PR-1 | 71 deg. |

**[Table 7]**

| No. | Contact angle | No. | Contact angle |
|---|---|---|---|
| Non-exposed PR-2 | 71 deg. | Non-exposed PR-2 | 53 deg. |

It was found that the contact angle (CA1) of a silicon-containing film shown in Table 4 and the contact angle of the upper resist for positive development shown in Table 6 are close with each other.
It was also found that the contact angle (CA2) of a silicon-containing film after exposure shown in Table 5 is significantly small compared with a Film 38 having only one hydroxyl group on a benzene ring.

### Patterning test by positive development

A spin-on carbon film ODL-50 (Product from Shin-Etsu Chemical Co., Ltd.: carbon content; 80% by mass) was formed on a silicon wafer with a film thickness of 200nm. A silicon-containing composition for forming a resist underlayer films (SOl. 11 to 38) were applied thereon and heated at 240°C for 60 seconds to prepare 35nm silicon-containing films (Films 11 to 38).

Subsequently, an ArF resist solution (PR-1) for positive development described in Table 8 was applied on the silicon-containing film and baked at 110°C for 60 seconds to form a 100nm photoresist layer. An immersion top coat (TC-1) described in Table 9 was further applied on the photoresist film and baked at 90°C for 60 seconds to form a 50nm top coat.
Subsequently, the product was subjected to exposure with an ArF immersion exposure device (Product from Nikon Corporation; NSR-S610C, NA=1.30, σ=0.98/0.65, 35-degree dipole polarized light illumination, 6%-attenuated phase shift mask, 45nm 1: 1 line-and-space pattern) with various exposure doses, baked at 100°C for 60 seconds (PEB), and developed with a 2.38% by mass tetramethylammonium hydroxide (TMAH) aqueous solution for 30 seconds. From the obtained pattern, a pattern size was measured with an electronic microscope (Product from Hitachi High-Technologies Corporation (CG4000) at the maximum exposure dose with no pattern fall, and the cross section was observed with an electronic microscope (Product from Hitachi Ltd. (S-9380)) (Table 10).

**[Table 8]**

| No. | Polymer (mass) | Acid generator (mass) | Base (mass) | Solvent (mass) |
|---|---|---|---|---|
| PR-1 | ArF resist polymer 1 (100) | PAG1 (7.0) | Quencher (1.0) | PGMEA (2,500) |

ArF resist polymer 1:
Molecular weight (Mw) =7,800
Degree of dispersion (Mw/Mn) =1.78 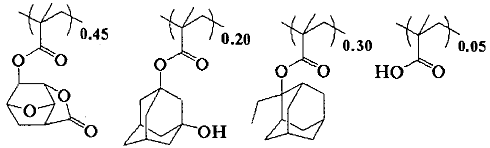 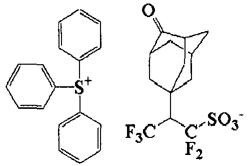
Acid generator: PAG1 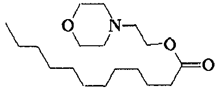
Base: Quencher 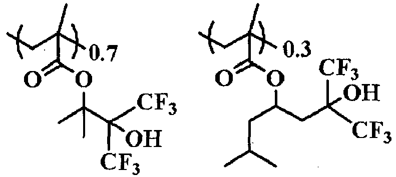
Top coat polymer
Molecular weight (Mw) =8,800
Degree of dispersion (Mw/Mn) =1.69

**[Table 9]**

| | Polymer (mass) | Organic solvent (mass) |
|---|---|---|
| TC-1 | Top coat polymer (100) | Diisoamyl ether (2700) |
| | | 2-methyl-butanol (270) |

**[Table 10]**

| Example | Silicon-containing resist underlayer film | ArF resist | Patten section after development | Pattern fall size |
|---|---|---|---|---|
| Example 1-1 | Film 11 | PR-1 | Vertical form | 36nm |
| Example 1-2 | Film 12 | PR-1 | Vertical form | 38nm |
| Example 1-3 | Film 13 | PR-1 | Vertical form | 36nm |
| Example 1-4 | Film 14 | PR-1 | Vertical form | 37nm |
| Example 1-5 | Film 15 | PR-1 | Vertical form | 39nm |
| Example 1-6 | Film 16 | PR-1 | Vertical form | 35nm |
| Example 1-7 | Film 17 | PR-1 | Vertical form | 36nm |
| Example 1-8 | Film 18 | PR-1 | Vertical form | 38nm |
| Example 1-9 | Film 19 | PR-1 | Vertical form | 38nm |
| Example 1-10 | Film 20 | PR-1 | Vertical form | 37nm |
| Example 1-11 | Film 21 | PR-1 | Vertical form | 37nm |
| Example 1-12 | Film 22 | PR-1 | Vertical form | 36nm |
| Example 1-13 | Film 23 | PR-1 | Vertical form | 37nm |
| Example 1-14 | Film 24 | PR-1 | Vertical form | 37nm |
| Example 1-15 | Film 25 | PR-1 | Vertical form | 36nm |
| Example 1-16 | Film 26 | PR-1 | Vertical form | 35nm |
| Example 1-17 | Film 27 | PR-1 | Vertical form | 38nm |
| Example 1-18 | Film 28 | PR-1 | Vertical form | 37nm |
| Example 1-19 | Film 29 | PR-1 | Vertical form | 39nm |
| Example 1-20 | Film 30 | PR-1 | Vertical form | 39nm |
| Example 1-21 | Film 31 | PR-1 | Vertical form | 35nm |
| Example 1-22 | Film 32 | PR-1 | Vertical form | 37nm |
| Example 1-23 | Film 33 | PR-1 | Vertical form | 37nm |
| Example 1-24 | Film 34 | PR-1 | Vertical form | 35nm |
| Comparative Example 1-1 | Film 35 | PR-1 | Vertical form | 38nm |
| Comparative Example 1-2 | Film 36 | PR-1 | Vertical form | 39nm |
| Comparative Example 1-3 | Film 37 | PR-1 | Vertical form | 37nm |
| Comparative Example 1-4 | Film 38 | PR-1 | Vertical form | 38nm |

As shown in Table 10, a vertical resist section was obtained in positive development. In every resist underlayer film material, the size of pattern fall was the same.

### Patterning test by negative development

A spin-on carbon film ODL-50 (Product from Shin-Etsu Chemical Co., Ltd.: carbon content; 80% by mass) was formed on a silicon wafer, with a film thickness of 200nm. Silicon-containing compositions for forming a resist underlayer films (SOl. 11 to 38) were applied thereon and heated at 240°C for 60 seconds to prepare 35nm silicon-containing films (Films 1 to 38).

Subsequently, an ArF resist solution for negative development (PR-2) described in Table 11 was applied on the silicon-containing film and baked at 100°C for 60 seconds to form a 100nm photoresist layer. An immersion top coat (TC-1) described in Table 9 was applied on the photoresist film and baked at 90°C for 60 seconds to form a 50nm top coat.

Next, the product was exposed with an ArF immersion exposure device (Product from Nikon Corporation; NSR-S610C, NA=1.30, σ=0.98/0.65, 35-degree dipole polarized light illumination, 6%-attenuated phase shift mask, 45nm 1: 1 line-and-space pattern) with various exposure doses and baked at 100°C for 60 seconds (PEB). After it was rotated at 30RPM to discharge butyl acetate as a developer from a developing nozzle for 3 seconds, the rotation was stopped to perform paddle development for 27 seconds. The product was rinsed with diisoamyl ether and spin-dried and baked at 100°C for 20 seconds to evaporate a rinsing solvent. From the obtained pattern, a pattern size at the minimum exposure dose with no pattern fall was measured with an electronic microscope (Product from Hitachi High-Technologies Corporation (CG4000)), and the cross section was observed with an electronic microscope (Product from Hitachi Ltd.(S-4700)) (Table 11).

**[Table 11]**

| No. | Polymer (mass) | Acid generator (mass) | Base (mass) | Solvent (mass) |
|---|---|---|---|---|
| PR-2 | ArF resist polymer 2 (100) | PAG2 (7.0) | Quenche r (1.0) | PGMEA (2,500) |

ArF resist polymer 2:
Molecular weight (Mw) =8,600
Degree of dispersion (Mw/Mn) =1.88 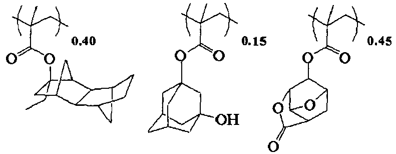 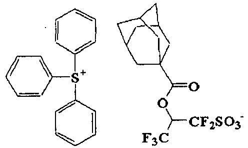
Acid generator: PAG2 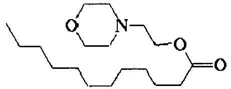
Base: Quencher

**[Table 12]**

| Example | Silicon-containing resist underlayer film | ArF resist | Patten section after development | Pattern fall size |
|---|---|---|---|---|
| Example 2-1 | Film 11 | PR-2 | Vertical form | 29nm |
| Example 2-2 | Film 12 | PR-2 | Vertical form | 29nm |
| Example 2-3 | Film 13 | PR-2 | Vertical form | 30nm |
| Example 2-4 | Film 14 | PR-2 | Vertical form | 31nm |
| Example 2-5 | Film 15 | PR-2 | Vertical form | 32nm |
| Example 2-6 | Film 16 | PR-2 | Vertical form | 30nm |
| Example 2-7 | Film 17 | PR-2 | Vertical form | 31nm |
| Example 2-8 | Film 18 | PR-2 | Vertical form | 31nm |
| Example 2-9 | Film 19 | PR-2 | Vertical form | 30nm |
| Example 2-10 | Film 20 | PR-2 | Vertical form | 30nm |
| Example 2-11 | Film 21 | PR-2 | Vertical form | 30nm |
| Example 2-12 | Film 22 | PR-2 | Vertical form | 29nm |
| Example 2-13 | Film 23 | PR-2 | Vertical form | 29nm |
| Example 2-14 | Film 24 | PR-2 | vertical form | 30nm |
| Example 2-15 | Film 25 | PR-2 | Vertical form | 30nm |
| Example 2-16 | Film 26 | PR-2 | Vertical form | 30nm |
| Example 2-17 | Film 27 | PR-2 | Vertical form | 32nm |
| Example 2-18 | Film 28 | PR-2 | Vertical form | 32nm |
| Example 2-19 | Film 29 | PR-2 | Vertical form | 30nm |
| Example 2-20 | Film 30 | PR-2 | Vertical form | 30nm |
| Example 2-21 | Film 31 | PR-2 | Vertical form | 32nm |
| Example 2-22 | Film 32 | PR-2 | Vertical form | 30nm |
| Example 2-23 | Film 33 | PR-2 | Vertical form | 31nm |
| Example 2-24 | Film 34 | PR-2 | Vertical form | 32nm |
| Comparative Example 2-1 | Film 35 | PR-2 | Vertical form | 46nm |
| Comparative Example 2-2 | Film 36 | PR-2 | Vertical form | 35nm |
| Comparative Example 2-3 | Film 37 | PR-2 | Vertical form | 46nm |
| Comparative Example 2-4 | Film 38 | PR-2 | Vertical form | 35nm |

As shown in Table 12, a silicon-containing resist underlayer film material was obtained by using a silicon compound having 2 hydroxyl groups protected by an acid labile group on a benzene ring of the present invention as a raw material. In negative developing processes (Example 2-1 to 2-24) by using a resist underlayer film obtained from the silicon-containing resist underlayer film material, a vertical resist section was observed and no pattern fall was confirmed for 30nm node devices. Meanwhile, in negative development of Comparative Examples 2-1 and 2-3 containing no organic group substituted with an acid labile group, even a relatively thick pattern included pattern fall. Also, even in resist underlayer films (Comparative Examples 2-2 and 2-4) obtained by using a silicon compound having only one hydroxyl group substituted with an acid labile group on a benzene ring as a raw material, a vertical resist section was obtained, but pattern fall was observed in 35nm-node devices. It was concluded that the films in the Comparative Examples are not so excellent in performance as the resist underlayer film containing the silicon compound of the present invention.

It must be stated here that the present invention is not restricted to the embodiments shown by Examples. The embodiments shown by Examples are merely examples so that any embodiments composed of substantially the same technical concept as disclosed in the claims of the present invention and expressing a similar effect are included in the technical scope of the present invention.

## Claims

1. A silicon compound represented by the following general formula (A-1) or (A-2), 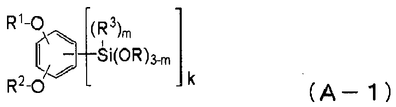 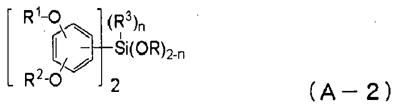 wherein, R represents a hydrocarbon group having 1 to 6 carbon atoms, R¹ and R² represent an acid labile group, R³ represents a hydrogen atom or a monovalent organic group having 1 to 30 carbon atoms, k represents an integer of 1 or 2, m represents an integer of 0, 1, or 2, and n represents an integer of 0 or 1.

2. The silicon compound according to claim 1, wherein an acid labile group of the R¹ and R² is an acetal group or a tertiary alkyl group.

3. A silicon-containing compound, comprising at least one or more kinds of the repeating units represented by the following general formula (B), (C), (D), and (E), 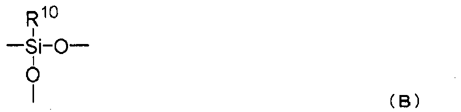 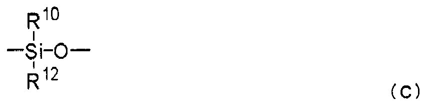 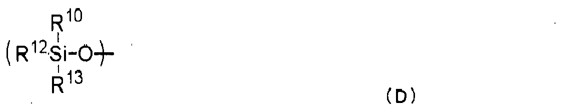 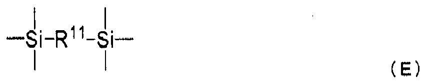 wherein, 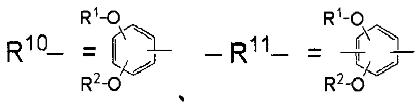 R¹ and R² represent an acid labile group, R¹² and R¹³ represent any of the R¹⁰, a hydrogen atom and a monovalent organic group having 1 to 30 carbon atoms, and if either one of the two is R¹⁰, R¹²#R¹³.

4. A silicon-containing composition for forming a resist underlayer film comprising the silicon-containing compound according to claim 3 and a solvent.

5. A patterning process comprising a step of forming an organic underlayer film on a body to be processed by using an application-type composition for organic underlayer film; a step of forming a silicon-containing resist underlayer film on the organic underlayer film by using the silicon-containing composition for forming a resist underlayer film according to claim 4; a step of forming a photoresist film on the silicon-containing resist underlayer film by using a chemically-amplified resist composition; a step of, after a heat-treatment, forming a positive pattern by exposure of the photoresist film by a high energy radiation and by dissolution of an exposed area of the photoresist film by using an alkaline developer; a step of transferring the pattern on the silicon-containing resist underlayer film by dry etching with the photoresist film having the formed positive pattern as a mask; a step of transferring the pattern on the organic underlayer film by dry etching with the silicon-containing resist underlayer film having the transferred pattern as a mask; and a step of further transferring the pattern on the body to be processed by dry etching with the organic underlayer film having the transferred pattern as a mask.

6. A patterning process comprising a step of forming an organic hard mask mainly comprising carbon on a body to be processed by CVD method; a step of forming a silicon-containing resist underlayer film on the organic hard mask by using the silicon-containing composition for forming a resist underlayer film according to claim 4; a step of forming a photoresist film on the silicon-containing resist underlayer film by using a chemically-amplified resist composition; a step of, after a heat-treatment, forming a positive pattern by exposure of the photoresist film by a high energy radiation and by dissolution of an exposed area of the photoresist film by using an alkaline developer; a step of transferring the pattern on the silicon-containing resist underlayer film by dry etching with the photoresist film having the formed positive pattern as a mask; a step of transferring the pattern on the organic hard mask by dry etching with the silicon-containing resist underlayer film having the transferred pattern as a mask; and further transferring the pattern on the body to be processed by dry etching with the organic hard mask having the transferred pattern as a mask.

7. A patterning process comprising a step of forming an organic underlayer film on a body to be processed by using an application-type composition for organic underlayer film; a step of forming a silicon-containing resist underlayer film on the organic underlayer film by using the silicon-containing composition for forming a resist underlayer film according to claim 4; a step of forming a photoresist film on the silicon-containing resist underlayer film by using a chemically-amplified resist composition; a step of, after a heat-treatment, forming a negative pattern by exposure of the photoresist film by a high energy radiation and by dissolution of a non-exposed area of the photoresist film by using a developer of an organic solvent; a step of transferring the pattern on the silicon-containing resist underlayer film by dry etching with the photoresist film having the formed negative pattern as a mask; a step of transferring the pattern on the organic underlayer film by dry etching with the silicon-containing resist underlayer film having the transferred pattern as a mask; and a step of further transferring the pattern on the body to be processed by dry etching with the organic underlayer film having the transferred pattern as a mask.

8. A patterning process comprising a step of forming an organic hard mask mainly comprising carbon on a body to be processed by CVD method; a step of forming a silicon-containing resist underlayer film on the organic hard mask by using the silicon-containing composition for forming a resist underlayer film according to claim 4; a step of forming a photoresist film on the silicon-containing resist underlayer film by using a chemically-amplified resist composition; a step of, after a heat-treatment, forming a negative pattern by exposure of the photoresist film by a high energy radiation and by dissolution of a non-exposed area of the photoresist film by using a developer of an organic solvent; a step of transferring the pattern on the silicon-containing resist underlayer film by dry etching with the photoresist film having the formed negative pattern as a mask; a step of transferring the pattern on the organic hard mask by dry etching with the silicon-containing resist underlayer film having the transferred pattern as a mask; and a step of further transferring the pattern on the body to be processed by dry etching with the organic hard mask having the transferred pattern as a mask.

9. The patterning process according to any one of claims 5 to 8, wherein the body to be processed is a semiconductor device substrate or a semiconductor device substrate coated with any of a metal film, an alloy film, a metal carbide film, a metal oxide film, a metal nitride film, a metal oxicarbide film, and a metal oxinitride film.

10. The patterning process according to claim 9, wherein the body to be processed comprises any metal of a silicon, a gallium, a titanium, a tungsten, a hafnium, a zirconium, a chromium, a germanium, a copper, an aluminum, and an iron, or an alloy thereof.
